# EUROPEAN PATENT APPLICATION

(11) **EP 4 478 857 A1**
(43) Date of publication of application: **18.12.2024**
(21) Application number: 24166236.0
(22) Date of filing: 26.03.2024
(51) Int. Cl.: H10B 43/10, H10B 43/27, H10B 43/50

(54) **SEMICONDUCTOR DEVICE AND ELECTRONIC SYSTEM INCLUDING THE SAME**

(30) Priority: 16.06.2023 KR 20230077408
(71) Applicant: Samsung Electronics Co., Ltd., Suwon-si, Gyeonggi-do 16677 (KR)
(72) Inventor: KANAMORI, Kohji, 16677 Suwon-si (KR); KANG, Seo-Goo, 16677 Suwon-si (KR); LEE, Seunghyun, 16677 Suwon-si (KR); HAN, Jeehoon, 16677 Suwon-si (KR)
(74) Representative: Marks & Clerk LLP

(57) **Abstract**

A semiconductor device and an electronic system are provided. The semiconductor device may include a substrate including a cell array region and a connection region, a stacked structure including conductive patterns stacked on the substrate, an inner supporter that extends into the stacked structure in the connection region, a contact plug that extends into a portion of the stacked structure and electrically connected to one of the conductive patterns and at least partially extends around the inner supporter in plan view, an insulating spacer between the contact plug and the stacked structure and at least partially extends around the contact plug, and outer supporters spaced apart from the contact plug in the connection region and extending into the stacked structure.

## Description

### BACKGROUND

The present disclosure relates to a semiconductor device and an electronic system including the same.

There is a demand for a semiconductor device capable of storing high-capacity data in an electronic system that requires data storage. Accordingly, techniques that may increase the data storage capacity of the semiconductor device are being researched. For example, as one of the methods for increasing the data storage capacity of the semiconductor device, a semiconductor device that includes three-dimensionally arranged memory cells instead of two-dimensionally arranged memory cells has been proposed.

### SUMMARY

Some example embodiments provide a semiconductor device with improved reliability and integration.

Some example embodiments provide an electronic system including a semiconductor device.

The present disclosure is not limited to the problems mentioned above, and other problems not mentioned will be clearly understood by those skilled in the art from the following description.

According to example embodiments, a semiconductor device may include a substrate including a connection region, a stacked structure including conductive patterns stacked on the substrate, an inner supporter that extends into the stacked structure in the connection region, a contact plug that extends into the stacked structure and is electrically connected to one of the conductive patterns and at least partially extends around the inner supporter in plan view, an insulating spacer between the contact plug and the stacked structure and at least partially extends around the contact plug in the plan view, and outer supporters spaced apart from the contact plug in the connection region and extend into the stacked structure.

According to example embodiments, a semiconductor device may include a substrate including a cell array region and a connection region, a stacked structure including conductive patterns stacked on the substrate, vertical channels that extend into the stacked structure in the cell array region, a first contact plug that extends into the stacked structure in the connection region and is electrically connected to a first conductive pattern among the conductive patterns, a second contact plug that extends into the stacked structure in the connection region and is electrically connected to a second conductive pattern among the conductive patterns, a first inner supporter that extends into the first contact plug, a second inner supporter that extends into the second contact plug, a first insulating spacer between the first contact plug and the stacked structure and at least partially extends around the first contact plug in plan view, a second insulating spacer between the second contact plug and the stacked structure and at least partially extends around the second contact plug, and a plurality of outer supporters that extends into the stacked structure and are spaced apart from the first and second contact plugs in the connection region.

According to example embodiments, an electronic system may include a semiconductor device including a substrate including a connection region, a stacked structure including conductive patterns stacked on the substrate, an inner supporter that extends into the stacked structure in the connection region, a contact plug that extends into a portion of the stacked structure and is electrically connected to one of the conductive patterns and at least partially extends around the inner supporter, an insulating spacer between the contact plug and the stacked structure and at least partially extending around the contact plug, outer supporters that extend into the stacked structure and are spaced apart from the contact plug, and an input/output pad electrically connected to peripheral circuits, and a controller electrically connected to the semiconductor device through the input/output pad and configured to control the semiconductor device.

Details of other embodiments are included in the detailed description and drawings.

At least some of the above and other features of the invention are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIGS. 1A and 1B are plan views of a semiconductor device according to some example embodiments of the present disclosure, FIG. 1A illustrates an upper surface of the semiconductor device and FIG. 1B illustrates a lower surface of the semiconductor device.
FIGS. 2A and 2B are cross-sectional views of a semiconductor device according to some example embodiments of the present disclosure, respectively, illustrating cross-sections taken along lines A-A' and B-B' of FIG. 1A.
FIG. 3A is an enlarged view of a portion 'P1' of FIG. 2A.
FIG. 3B is an enlarged view of a portion `P2' of FIG. 2A.
FIGS. 4, 5, 6, and 7 are plan views of a semiconductor device according to some example embodiments of the present disclosure.
FIG. 8 is a plan view of a semiconductor device according to some example embodiments of the present disclosure.
FIG. 9 is a cross-sectional view of a semiconductor device according to some example embodiments of the present disclosure, each illustrating a cross-section taken along the line A-A' of FIG. 8.
FIG. 10 is an enlarged view of a portion `P3' of FIG. 9.
FIG. 11 is a cross-sectional view of a semiconductor device according to some example embodiments of the present disclosure, taken along the line A-A' of FIG. 8.
FIG. 12 is a cross-sectional view of a semiconductor device according to some example embodiments of the present disclosure, taken along the line A-A' of FIG. 8.
FIGS. 13A, 14A, 15A, 16A, 17A, 18A, 19A, 20A, and 21A are views for illustrating a method of manufacturing a semiconductor device according to some example embodiments of the present disclosure, and illustrate cross-sections taken along the line A-A' of FIG. 5.
FIGS. 13B, 14B, 15B, 16B, 17B, 18B, 19B, 20B, and 21B are views for illustrating a method of manufacturing a semiconductor device according to some example embodiments of the present disclosure, and illustrate cross-sections taken along line B-B' of FIG. 5.
FIGS. 22, 23, 24, and 25 are views for illustrating a method of manufacturing a semiconductor device according to some example embodiments of the present disclosure, and illustrate cross-sections taken along line A-A' of FIG. 5.
FIG. 26 is a diagram schematically illustrating an electronic system including a semiconductor device according to some example embodiments of the present disclosure.
FIG. 27 is a schematic perspective view of an electronic system including a semiconductor device according to some example embodiments of the present disclosure.
FIGS. 28 and 29 are cross-sectional views schematically illustrating semiconductor packages according to some example embodiments of the present disclosure.

### DETAILED DESCRIPTION

Hereinafter, a semiconductor device and an electronic system including the same according to embodiments of the inventive concepts will be described in detail with reference to the accompanying drawings. Some of the drawings refer to particular directions, e.g. identified as D1, D2, D3 etc. It will be appreciated that these are examples, and furthermore that the directions are relative to a device and do not imply any particular orientation of that device.

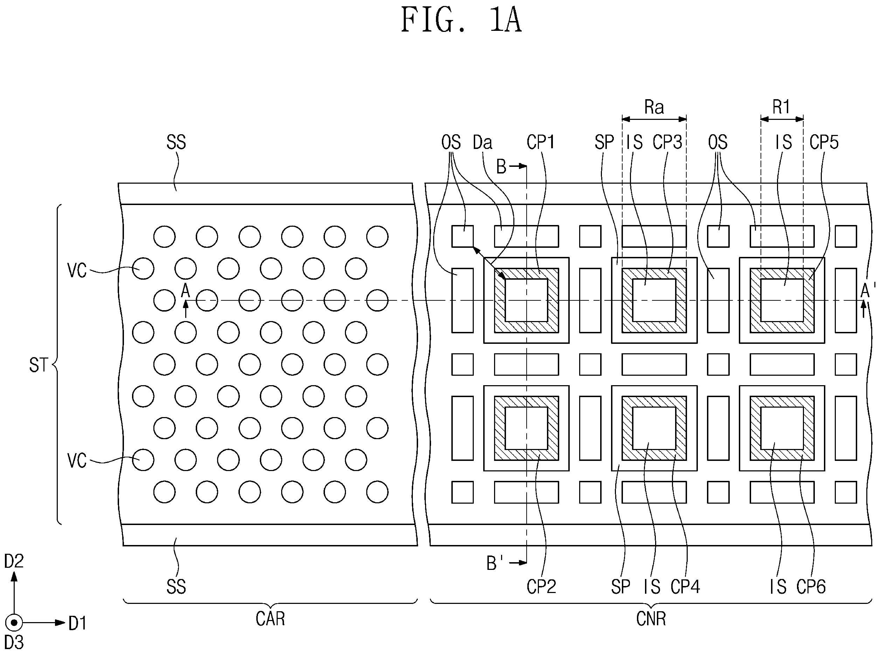

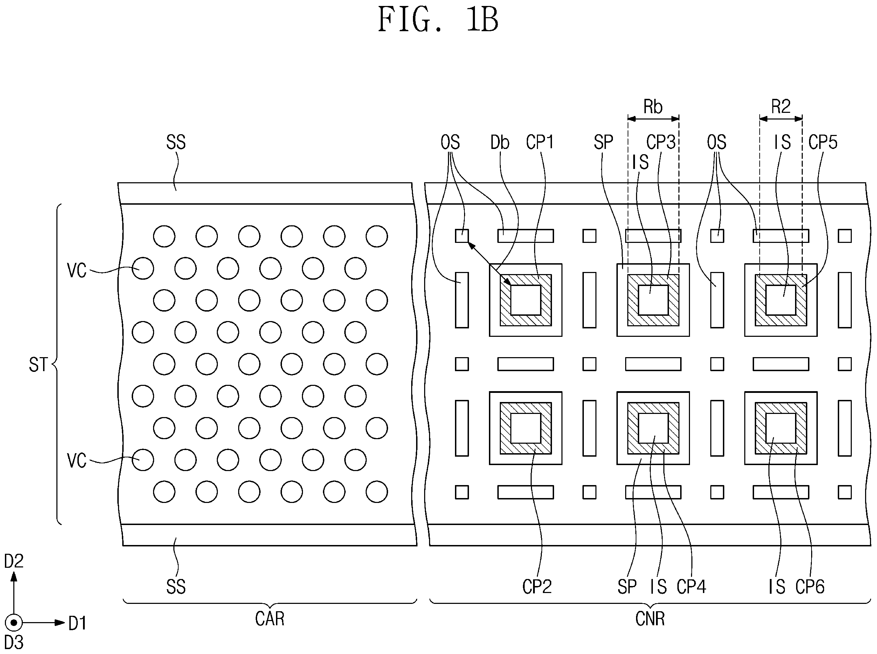

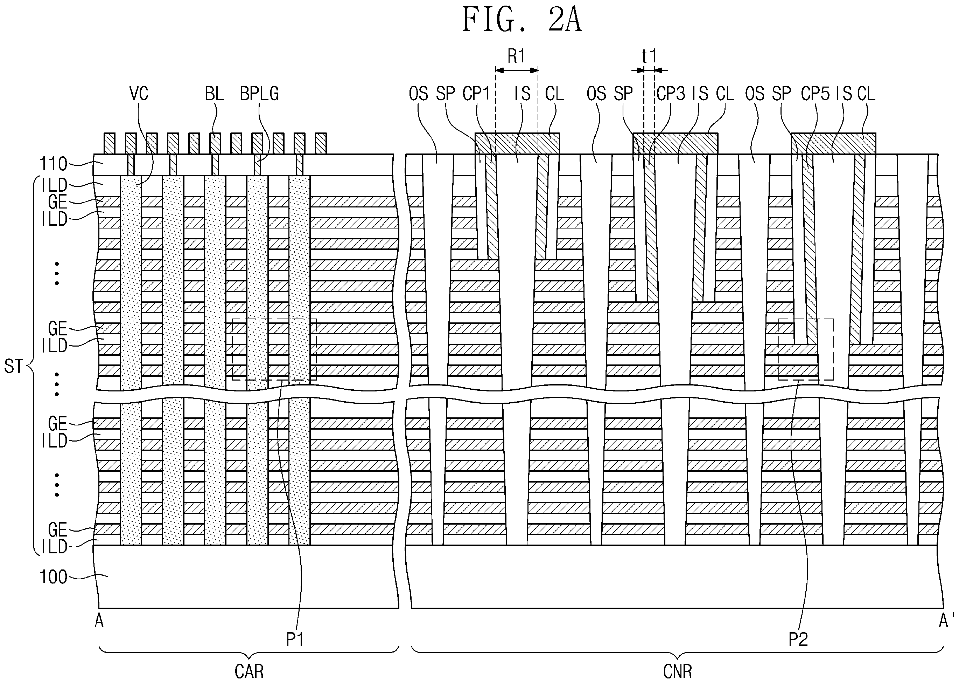

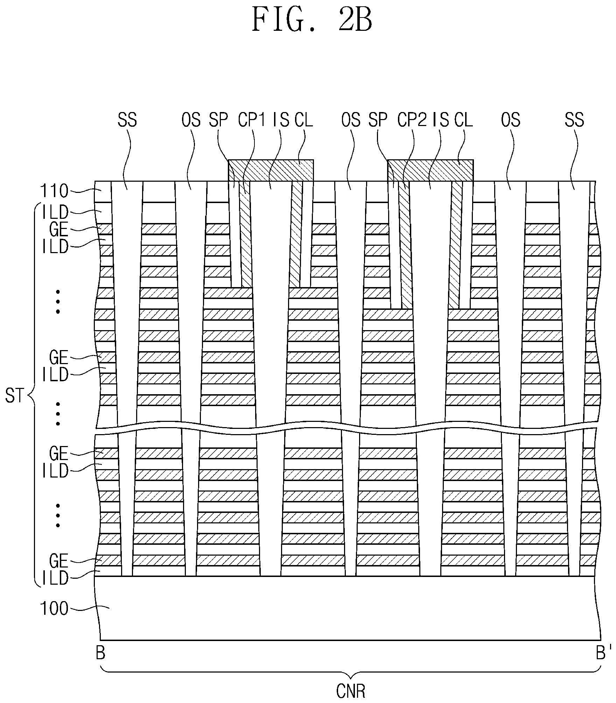

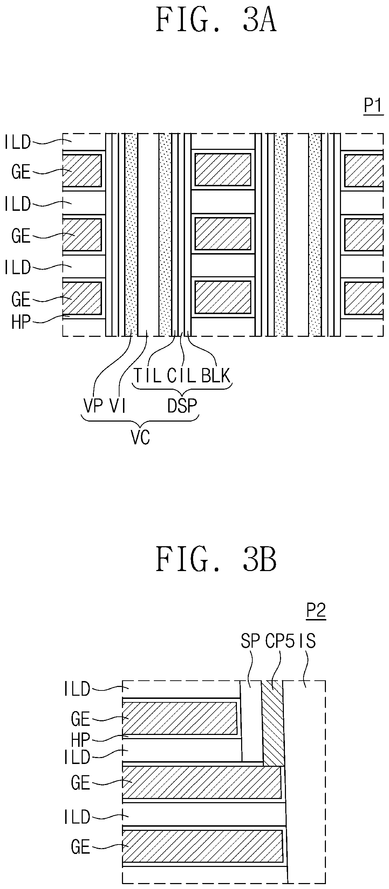

FIGS. 1A and 1B are plan views of a semiconductor device according to some example embodiments of the present disclosure, FIG. 1A illustrates an upper surface of the semiconductor device and FIG. 1B illustrates a lower surface of the semiconductor device. FIGS. 2A and 2B are cross-sectional views of a semiconductor device according to some example embodiments of the present disclosure, respectively, illustrating cross-sections taken along lines A-A' and B-B' of FIG. 1A. FIG. 3A is an enlarged view of a portion 'P1' of FIG. 2A. FIG. 3B is an enlarged view of a portion `P2' of FIG. 2A.

Referring to FIGS. 1A, 1B, 2A, and 2B, a semiconductor device according to some example embodiments may include a substrate 100, a stacked structure ST, vertical structures VC, inner and outer supporters IS and OS, cell contact plugs CP, bit lines BL, and connection lines CL.

The substrate 100 may include a cell array region CAR and a connection region CNR. The substrate 100 may include, for example, at least one of silicon (Si), germanium (Ge), silicon germanium (SiGe), gallium arsenide (GaAs), indium gallium arsenide (InGaAs), aluminum gallium arsenide (AlGaAs), or a mixture thereof. The substrate 100 may include a semiconductor doped with impurities and/or an intrinsic semiconductor in which impurities are not doped. The substrate 100 may have a crystal structure including at least one selected from single crystal, amorphous, and polycrystalline. As another example, the substrate 100 may be formed of an insulating material such as silicon oxide.

The stacked structure ST may be disposed on the substrate 100. The stacked structure ST may extend in a first direction D1 from the cell array region CAR to the connection region CNR. The stacked structure ST may have a uniform thickness on the cell array region CAR and the connection region CNR.

The stacked structure ST may include conductive patterns GE and insulating layers ILD alternately stacked in a third direction D3 (i.e., a vertical direction) perpendicular to first and second directions D1 and D2 crossing each other. The conductive patterns GE may include, for example, at least one selected from a doped semiconductor (e.g., doped silicon, etc.), a metal (e.g., tungsten, copper, aluminum, etc.), a conductive metal nitride (e.g., titanium nitride, tantalum nitride, etc.), or transition metals (e.g., titanium, tantalum, etc.). The insulating layers ILD may include a silicon oxide layer and/or a low dielectric layer. According to embodiments, the semiconductor device may be a vertical NAND flash memory device, and in this case, the conductive patterns GE of the stacked structure ST may be used as gate electrode of a string select transistor, memory cell transistors, and/or ground selection transistors of the NAND flash memory device.

A plurality of vertical structures VC may pass through the stacked structure ST in the cell array region CAR. The vertical structures VC may be arranged in one direction or in a zigzag form when viewed in a plan view.

Each of the vertical structures VC may have a maximum width on an upper surface of an uppermost insulating layer ILD. Each of the vertical structures VC may have a minimum width at a bottom surface thereof, and the minimum width may be smaller than the maximum width. In some embodiments, each of the vertical structures VC may have substantially the same width at the upper surface thereof and at the bottom surface thereof. A distance between adjacent vertical structures VC may be smaller than the maximum width of each of the vertical structures VC.

In detail, referring to FIG. 3A, each of the vertical structures VC may include a vertical semiconductor pattern VP, a data storage pattern DSP surrounding a sidewall of the vertical semiconductor pattern VP, and a gap-fill insulating pattern VI inside vertical semiconductor pattern VP in plan view.

In detail, the vertical semiconductor pattern VP may have a pipe shape or a macaroni shape with a closed bottom. The vertical semiconductor pattern VP may have a U-shape, and the inside of the vertical semiconductor pattern VP may be at least partially filled with the gap-fill insulating pattern VI. A bit line conductive pad may be formed on an upper end of the vertical semiconductor pattern VP, and the bit line conductive pad may be formed of a semiconductor material undoped with impurities, a semiconductor material doped with impurities, or a conductive material.

The vertical semiconductor pattern VP may include a semiconductor material such as silicon (Si), germanium (Ge), or a mixture thereof. The vertical semiconductor pattern VP including a semiconductor material may be used as channels of memory cell transistors constituting a cell string.

The data storage pattern DSP extends in the third direction D3 and may surround sidewalls of each vertical semiconductor pattern VP in plan view. The data storage pattern DSP may have a pipe shape with upper and lower ends open, or a macaroni shape. The data storage pattern DSP may be composed of one thin layer or a plurality of thin layers. In some embodiments of the inventive concepts, the data storage pattern DSP may be a data storage layer of a NAND flash memory device, and may include a tunnel insulating layer TIL, a charge storage layer CIL, and a blocking insulating layer BLK sequentially stacked on the sidewall of the vertical semiconductor pattern VP. For example, the charge storage layer CIL may be a trap insulating layer, a floating gate electrode, or an insulating layer including conductive nano dots. In detail, the charge storage layer CIL may include at least one of a silicon nitride layer, a silicon oxynitride layer, a silicon-rich nitride layer, nanocrystalline silicon, and/or a laminated trap layer. The tunnel insulating layer TIL may include at least one material having a larger band gap than the charge storage layer CIL, and the blocking insulating layer BLK may be a high dielectric layer such as an aluminum oxide layer or a hafnium oxide layer.

A horizontal insulating pattern HP may be provided between one sidewalls of the conductive patterns GE and the data storage pattern DSP. The horizontal insulating pattern HP may extend to upper and lower surfaces of one sidewalls of the conductive patterns GE. The horizontal insulating pattern HP may include, for example, a silicon oxide layer and/or a high dielectric layer.

Again, referring to FIGS. 2A and 2B, the first interlayer insulating layer 110 may cover or overlap upper surfaces of the vertical structures VC on the stacked structure ST.

Bit lines BL extending in the second direction D2 may be disposed on the first interlayer insulating layer 110 in the cell array region CAR. The bit lines BL may be electrically connected to the vertical structures VC through bit line contact plugs BPLG.

Separation structures SS may extend in the first direction D1 from the cell array region CAR to the connection region CNR. The separation structures SS may be spaced apart in the second direction D2 crossing the first direction D1. The separation structures SS may include insulating layers covering or overlapping both side walls of the stacked structure ST. Each of the separation structures SS may have a single-layer or multi-layer structure. Upper surfaces of the separation structures SS may be positioned at substantially the same level as an upper surface of the first interlayer insulating layer 110. In the separation structures SS, a width of a lower portion may be smaller than a width of an upper portion.

According to some example embodiments, the inner supporters IS and the outer supporters OS may pass through the first interlayer insulating layer 110 and the stacked structure ST in the connection region CNR.

The inner supporters IS may pass through the first interlayer insulating layer 110 and the stacked structure ST in the connection region CNR. The inner supporters IS may be spaced apart from each other in the first and second directions D1 and D2. The inner supporters IS may have substantially the same width (or diameter) as one another. Their widths may for example be the same, within a manufacturing tolerance. The inner supporters IS may have substantially the same vertical length as one another in the third direction D3. Their vertical lengths may for example be the same within manufacturing tolerances. Each of the inner supporters IS may have a first upper width R1 at an upper surface thereof, and may have a first lower width R2 at a lower surface thereof. Each of the inner supporters IS may have a first lower width R2 smaller than the first upper width R1. Each of the inner supporters IS may be an insulating pillar formed of an insulating material.

Each of the inner supporters IS may include a lower portion in contact with the stacked structure ST and an upper portion in contact with a contact plug. Upper surfaces of the inner supporters IS may be positioned at different levels from upper surfaces of the vertical structures VC (i.e., at different distances from the substrate 100). The upper surfaces of the inner supporters IS may be positioned at substantially the same level or distance from substrate 100 as the upper surface of the first interlayer insulating layer 110. Each of the inner supporters IS may have a circular, elliptical, rectangular, or polygonal upper surface. For example, each of the inner supporters IS may have a quadrangular upper surface.

For example, each of the inner supporters IS may be disposed between two outer supporters OS adjacent to each other in the first direction D1 and may be disposed between two outer supporters OS adjacent to each other in the second direction D2.

According to some example embodiments, contact plugs CP1, CP2, CP3, CP4, CP5, and CP6 may penetrate the first interlayer insulating layer 110 and the stacked structure ST in the connection region CNR to be connected to the conductive patterns GE, respectively. Referring to FIG. 3B, each contact plug CP1 to CP6 may be in direct contact with the upper surface of the corresponding conductive pattern GE. The contact plugs CP1 to CP6 may include, for example, at least one of a metal (e.g., tungsten, copper, aluminum, etc.), a conductive metal nitride (e.g., titanium nitride, tantalum nitride, etc.) or a transition metal (e.g., titanium, tantalum, etc.).

The contact plugs CP1 to CP6 may be spaced apart from each other in the first and second directions D1 and D2 in the connection region CNR. The contact plugs CP1 to CP6 may have different vertical lengths. The vertical lengths of the contact plugs CP1 to CP6 may decrease as the contact plugs CP1 to CP6 are closer to the cell array region CAR. The contact plugs CP1 to CP6 may have bottom surfaces positioned at different levels and upper surfaces positioned at the same level as each other with respect to the substrate 100. The upper surfaces of the contact plugs CP1 to CP6 may be substantially coplanar (for example functionally coplanar) with the upper surface of the first interlayer insulating layer 110.

For example, the contact plugs may include first to sixth contact plugs CP1 to CP6, and the first to sixth contact plugs CP1 to CP6 may be respectively connected to the conductive patterns GE positioned at different levels. For example, the first, third, and fifth contact plugs CP1, CP3, and CP5 may be spaced apart from each other in the first direction D1, and the second, fourth, and sixth contact plugs CP2, CP4, and CP6 may be disposed apart from the first, third, and fifth contact plugs CP1, CP3, and CP5 in the second direction D2. For example, the first, third, and fifth contact plugs CP1, CP3, and CP5 may be connected to the odd-numbered conductive patterns GE, and the second, fourth, and sixth contact plugs CP2, CP4, and CP6 may be connected to even-numbered conductive patterns GE.

Each of the contact plugs CP1 to CP6 may surround an upper portion of the inner supporter IS. Each of the contact plugs CP1 to CP6 may have a closed curve shape or a ring shape. Each of the contact plugs CP1 to CP6 may for example have a circular, elliptical, rectangular, or polygonal upper surface.

The contact plugs CP1 to CP6 may be surrounded by the stacked structure ST in plan view. Each of the contact plugs CP1 to CP6 may have a maximum width Ra at an upper surface thereof and a minimum width Rb at a lower surface thereof. The contact plugs CP1 to CP6 may have a greater width than the vertical structures VC.

Each contact plug CP1 to CP6 may be disposed between the inner supporter IS and the outer supporters OS adjacent thereto. Each contact plug CP1 to CP6 may have first thickness t1 between a sidewall of the insulating spacer SP and a sidewall of the inner supporter IS, and the first thickness t1 may be smaller than a diameter R1 and R2 of the inner supporter IS.

Insulating spacers SP may be disposed between the contact plugs CP1 to CP6 and the stacked structure ST. The insulating spacers SP may surround the contact plugs CP1 to CP6, respectively. The insulating spacers SP may be in direct contact with sidewalls of the contact plugs CP1 to CP6. The insulating spacer SP may include, for example, at least one of silicon oxide, silicon nitride, silicon oxynitride, and/or low dielectric. Referring to FIG. 3B, a portion of the horizontal insulating pattern HP may be disposed between each insulating spacer SP and the conductive pattern GE.

The insulating spacers SP may have different vertical lengths. The vertical lengths of the insulating spacers SP may decrease as the insulating spacers SP are closer to the cell array region CAR. The insulating spacers SP may have bottom surfaces positioned at different levels and upper surfaces positioned at the same level. The upper surfaces of the insulating spacers SP may be positioned at substantially the same level as the upper surfaces of the contact plugs CP1 to CP6.

The outer supporters OS may be disposed around each of the contact plugs CP1 to CP6 when viewed in a plan view. Each of the outer supporters OS may be an insulating pillar formed of an insulating material.

The outer supporters OS may be spaced apart from each other in the first and second directions D1 and D2. Also, the outer supporters OS may be spaced apart from each other in an oblique direction with respect to the first and second directions D1 and D2.

Each contact plug CP1 to CP6 may be disposed between two outer supporters OS adjacent to each other in the first direction D1, and each contact plug CP1 to CP6 may be disposed between two outer supporters OS adjacent to each other in the second direction D2.

The outer supporters OS may have a circular shape, a rectangular shape, a bar shape, or an elliptical shape when viewed in a plan view. Some of the outer supporters OS may have a bar shape having long axes in the first or second directions D1 or D2. The number, size, and shape of the outer supporters OS may be variously modified.

A width of each of the outer supporters OS may be smaller than that of the inner supporter IS. Each of the outer supporters OS may have a smaller width than the upper width. Each of the outer supporters OS may be an insulating pillar formed of an insulating material. The outer supporters OS may have substantially the same vertical length in the third direction D3. Upper surfaces of the outer supporters OS may be positioned at substantially the same level as the upper surface of the first interlayer insulating layer 110.

Each of the contact plugs CP1 to CP6 may have a maximum diameter Ra at the upper surface thereof. Each of the contact plugs CP1 to CP6 may have a minimum diameter Rb at the lower surface thereof.

The inner and outer supporters IS and OS adjacent thereto may be spaced apart from each other with a minimum distance Da at bottom surfaces thereof.

The inner and outer supporters IS and OS adjacent thereto may be spaced apart from each other with a maximum distance Db at upper surfaces thereof. For example, the maximum distance Db between the inner and outer supporters IS and OS adjacent thereto may be about 300 nm to about 500 nm, but the inventive concepts is not limited thereto.

Connection lines CL may be disposed on the first interlayer insulating layer 110 of the connection region CNR, and the connection lines CL may be connected to the contact plugs CP1 to CP6, respectively.

Hereinafter, a semiconductor device according to various example embodiments of the inventive concepts will be described, and detailed descriptions of technical features overlapping those of the above-described embodiments will be omitted, and differences will be described.

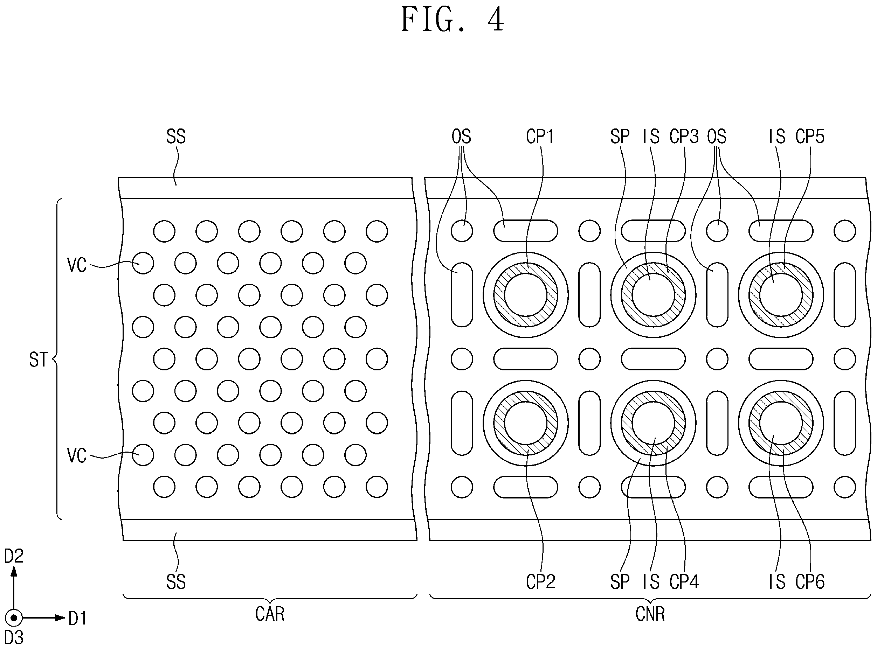

FIGS. 4, 5, 6, and 7 are plan views of a semiconductor device according to some example embodiments of the present disclosure.

According to the example embodiment illustrated in FIG. 4, each of the inner supporters IS may have a circular upper surface. That is, each of the inner supporters IS may have a circular pillar shape. Each of the outer supporters IS may have a circular or elliptical upper surface.

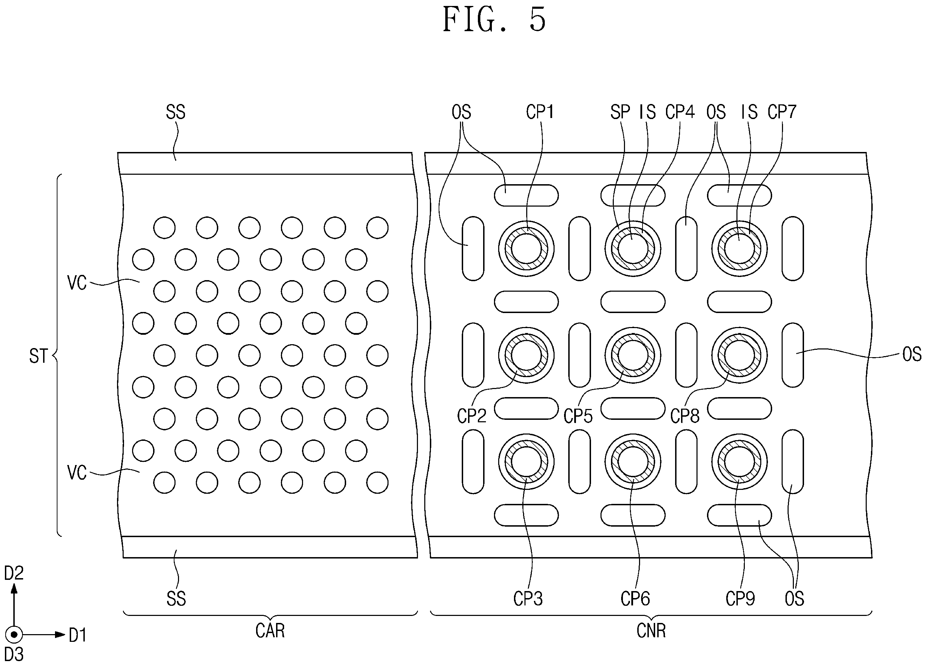

According to the example embodiment illustrated in FIG. 5, the inner and outer supporters IS and OS may penetrate the stacked structure ST in the connection region CNR, and the contact plugs CP1 to CP9 may surround the inner supporters IS, respectively, in plan view. The contact plugs CP1 to CP9 may form three columns, and each column may include a plurality of contact plugs CP1 to CP9 arranged in the first direction D1. For example, the contact plugs may include first, second, and third contact plugs CP1, CP2, and CP3 spaced apart from each other in the second direction D2, and fourth, fifth, and sixth contact plugs CP4, CP5, and CP6 spaced apart from each other in the second direction D2, and seventh, eighth, and ninth contact plugs CP7, CP8, and CP9 spaced apart from each other in the second direction D2. As described above, the contact plugs CP1 to CP9 may have different vertical lengths in the third direction D3. Also, insulating spacers SP may be respectively disposed between the contact plugs CP1 to CP9 and the stacked structure ST.

In the example embodiments, it is illustrated that the contact plugs are arranged in two or three rows in the second direction D2, but the inventive concepts are not limited thereto, and the contact plugs may be arranged in one row or may be arranged in four or more rows.

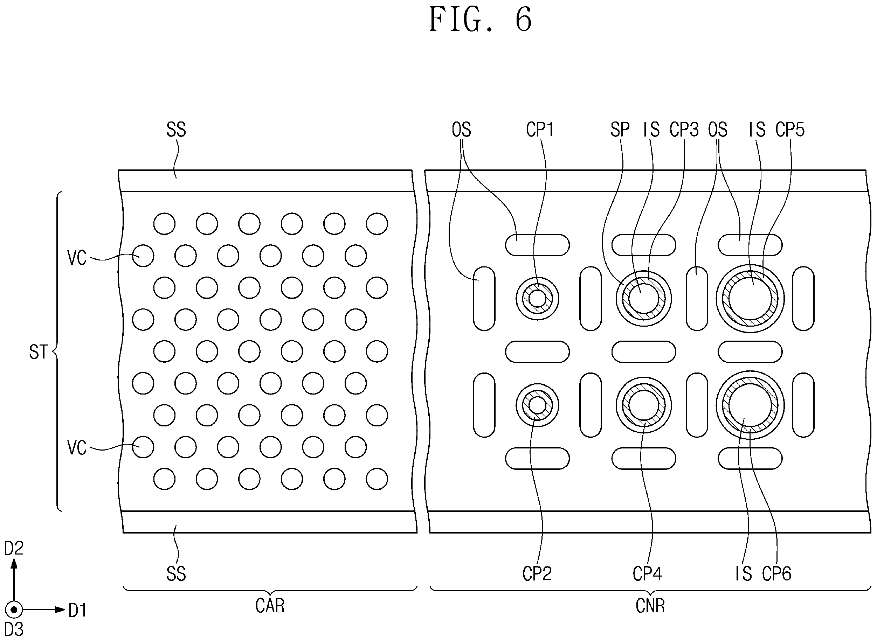

According to the example embodiment illustrated in FIG. 6, a width of the inner supporters IS may increase as a distance from the cell array region CAR increases. Accordingly, widths of the contact plugs CP1 to CP6 may also increase as the distance from the cell array region CAR increases. Conversely, the widths of the inner supporters IS and the contact plugs CP1 to CP6 may decrease as the distance from the cell array region CAR increases.

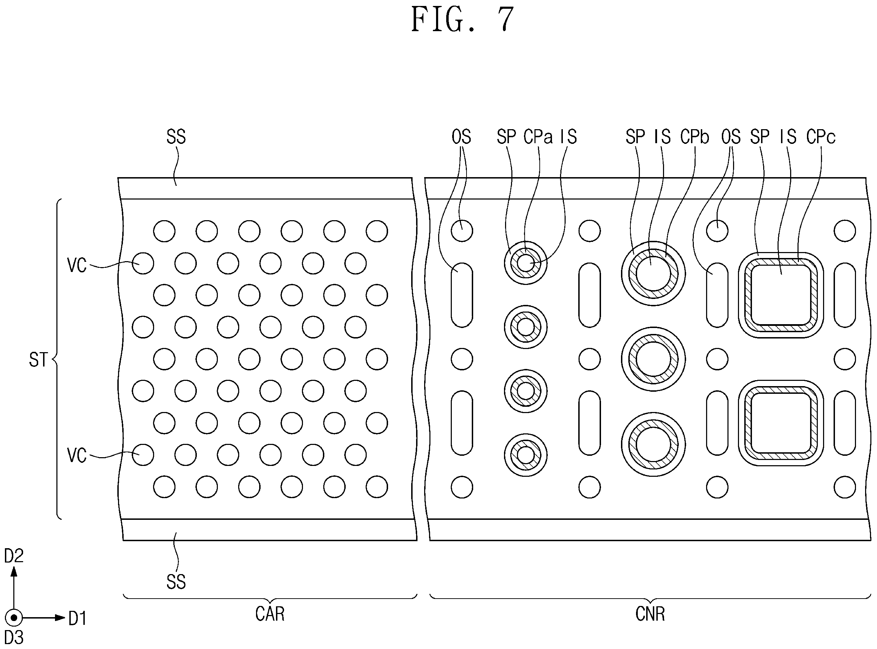

According to the example embodiment illustrated in FIG. 7, widths of the inner supporters IS arranged in the first direction D1 may be different from each other, and the number of contact plugs CPa, CPb, and CPc may be various depending on the distance from the cell array region CAR.

In detail, the contact plugs may include first contact plugs CPa having a first width, second contact plugs CPb having a second width greater than the first width, and a third contact plugs CPc having a third width greater than the second width.

The first contact plugs CPa may be disposed at a first distance from the vertical structure VC of the cell array region CAR, and the second contact plugs CPb may be disposed at a second distance greater than the first distance from the vertical structure VC of the cell array region CAR, the third contact plugs CPc may be disposed at a third distance greater than the second distance from the vertical structure VC of the cell array region CAR.

According to some example embodiments, '1' (e.g., four) first contact plugs CPa may be spaced apart from each other in the second direction D2, and 'm' (e.g., three) second contact plugs CPb, which are less than '1' may be spaced apart from each other in the second direction D2. In addition, 'n' (e.g., two) third contact plugs CPc which are fewer than 'm' may be spaced apart from each other in the second direction D2.

As described above, each of the first, second, and third contact plugs CPa, CPb, and CPc may surround an upper portion of the inner supporter IS, and the insulating spacers SP may surround each of the first, second, and third contact plugs CPa, CPb, and CPc.

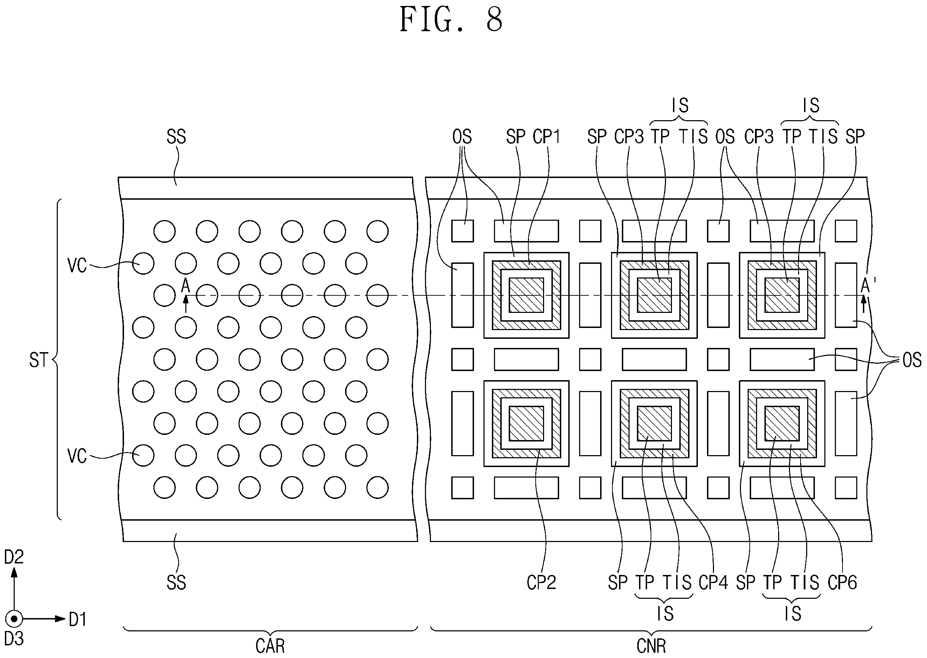

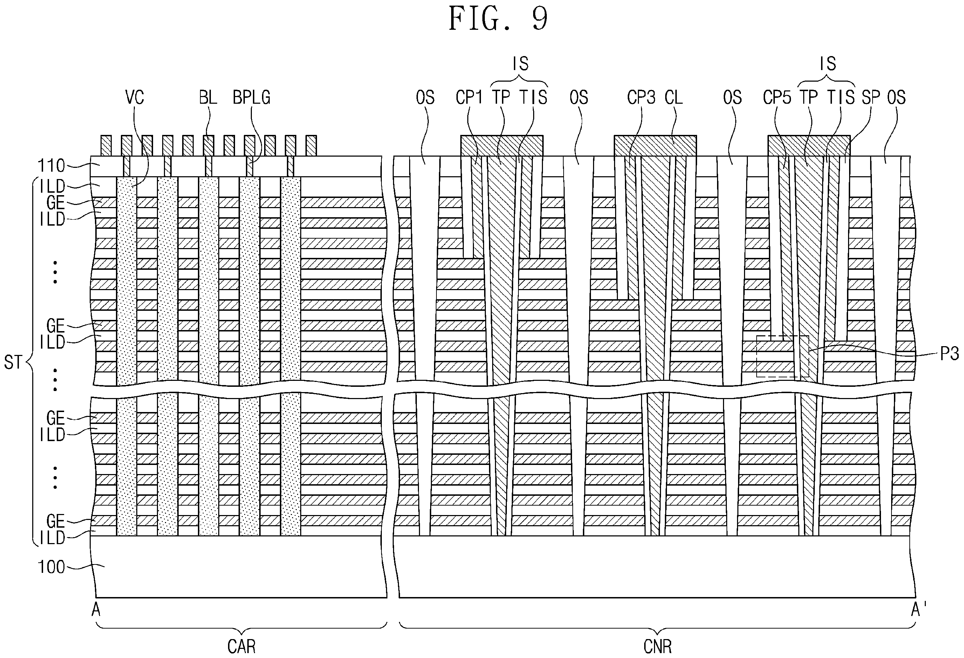

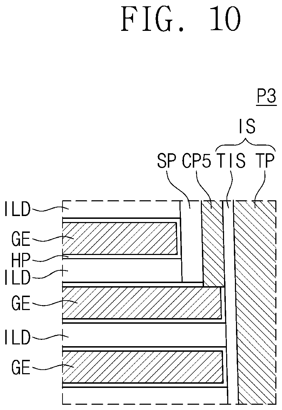

FIG. 8 is a plan view of a semiconductor device according to some example embodiments of the present disclosure. FIG. 9 is a cross-sectional view of a semiconductor device according to some example embodiments of the present disclosure, each illustrating a cross-section taken along the line A-A' of FIG. 8. FIG. 10 is an enlarged view of a portion `P3' of FIG. 9.

Referring to FIGS. 8 and 9, a semiconductor device according to some example embodiments may include a substrate 100, a stacked structure ST, vertical structures VC, inner and outer supporters IS and OS, cell contact plugs CP, through conductive plugs TP, bit lines BL, and connection lines CL.

According to some example embodiments, each of the inner supporters IS may include the through conductive plug TP penetrating the stacked structure ST and a through insulating spacer TIS surrounding the through conductive plug TP in plan view. The through insulating spacer TIS may insulate the contact plugs CP1 to CP6 and the through conductive plug TP, and may insulate the stacked structure ST and the through conductive plug TP.

The through conductive plug TP may include the same conductive material as the contact plugs CP1 to CP6. The through insulating spacer TIS may include an insulating material such as silicon oxide or silicon nitride.

The through conductive plugs TP of the inner supporters IS may have substantially the same length in the third direction D3. In some embodiments, the through conductive plugs TP of the inner supporters IS may have different lengths in the third direction D3 and may be connected to the conductive patterns GE of different levels.

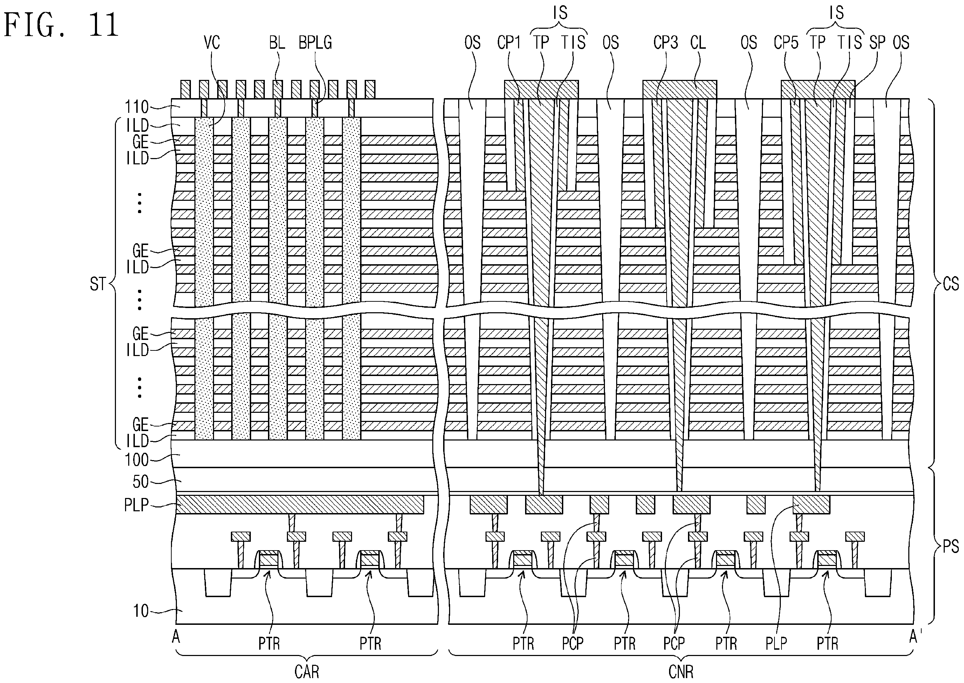

FIG. 11 is a cross-sectional view of a semiconductor device according to some example embodiments of the present disclosure, taken along the line A-A' of FIG. 8.

Referring to FIG. 11, a semiconductor device according to some example embodiments may include a peripheral circuit structure PS and a cell array structure CS on the peripheral circuit structure PS.

The peripheral circuit structure PS may include peripheral circuits PTR integrated on an upper surface of the semiconductor substrate 10 and a lower insulating layer 50 covering the peripheral circuits PTR. The semiconductor substrate 10 may be a silicon substrate. The semiconductor substrate 10 may include a cell array region CAR and a connection region CNR.

The peripheral circuits PTR may include row and column decoders, a page buffer, and a control circuit. In detail, the peripheral circuits PTR may include NMOS and PMOS transistors. The peripheral circuit wirings PLP may be electrically connected to the peripheral circuits PTR through peripheral contact plugs PCP.

A lower insulating layer 50 may be provided on the upper surface of the semiconductor substrate 10. The lower insulating layer 50 may cover or overlap the peripheral circuits PTR, the peripheral contact plugs PCP, and peripheral circuit wirings PLP on the semiconductor substrate 10. The peripheral contact plugs PCP and the peripheral circuit wirings PLP may be electrically connected to the peripheral circuits PTR.

The lower insulating layer 50 may include insulating layers stacked in multiple layers. For example, the lower insulating layer 50 may include a silicon oxide layer, a silicon nitride layer, a silicon oxynitride layer, and/or a low dielectric layer.

A cell array structure CS may be disposed on the lower insulating layer 50. The cell array structure CS may include a substrate 100, a stacked structure ST, vertical structures VC, inner and outer supporters IS and OS, cell contact plugs CP, through contact plugs TP, bit lines BL, and connection lines CL.

As described with reference to FIGS. 8 and 9, each of the inner supporters IS may include a through conductive plug TP penetrating the stacked structure ST and a through insulating spacer TIS surrounding the through conductive plug TP. For example, the through conductive plug TP may extend vertically and be connected to the peripheral circuit wirings PLP of the peripheral circuit structure PS.

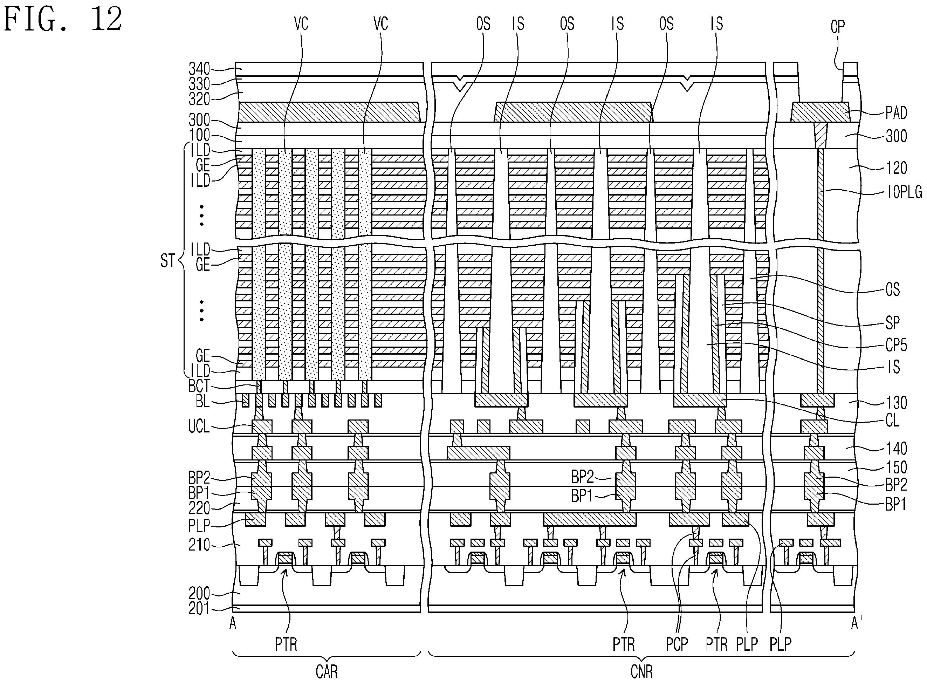

FIG. 12 is a cross-sectional view of a semiconductor device according to an embodiment of the inventive concepts, taken along the line A-A' of FIG. 8.

Referring to FIG. 12, a semiconductor device according to some example embodiments may have a chip to chip (C2C) structure. The C2C structure may mean that, after fabricating an upper chip including a cell array structure CS on a first wafer and fabricating a lower chip including a peripheral circuit structure PS on a second wafer different from the first wafer, the upper chip and the lower chip are connected to each other in a bonding manner. For example, the bonding manner may refer to a method of electrically connecting a bonding metal formed on an uppermost metal layer of the upper chip and a bonding metal formed on an uppermost metal layer of the lower chip to each other. For example, when the bonding metal is formed of copper (Cu), the bonding manner may be a Cu-to-Cu bonding manner, and the bonding metal may also be formed of aluminum (Al) or tungsten (W). One skilled in the art will be aware of numerous such bonding techniques suitable for the present purpose.

A semiconductor device according to embodiments of the inventive concepts may include a peripheral circuit structure PS on a semiconductor substrate 200 and a cell array structure CS on the peripheral circuit structure PS.

According to some example embodiments, as the cell array structure CS is combined with the peripheral circuit structure PS, a cell capacity per unit area of the semiconductor device according to the inventive concepts may be increased. In addition, the semiconductor device according to the inventive concepts may prevent damage to the peripheral circuits PTR due to various heat treatment processes through a method of manufacturing the peripheral circuit structure PS and the cell array structure CS and combining them with each other, thereby improving electrical characteristics and reliability thereof.

In detail, the peripheral circuit structure PS may include the semiconductor substrate 200, peripheral circuits PTR controlling the memory cell array, and peripheral interlayer insulating layers 210 and 220 covering or overlapping the peripheral circuits PTR. The peripheral circuits PTR may be integrated on an upper surface of the semiconductor substrate 200. A surface insulating layer 201 may be provided on a rear surface of the semiconductor substrate 200.

The semiconductor substrate 200 may be, for example, a silicon substrate, a silicon-germanium substrate, a germanium substrate, or a monocrystalline epitaxial layer grown on a monocrystalline silicon substrate. The semiconductor substrate 200 may have an upper surface parallel to a first direction D 1, and a second direction D2 crossing the first direction D1 and perpendicular to a third direction D3. The first to third directions D1, D2, and D3 may be perpendicular to each other, for example.

The peripheral circuits PTR may include row and column decoders, a page buffer, and a control circuit. In detail, the peripheral circuits PTR may include NMOS and PMOS transistors. The peripheral circuit wirings PLP may be electrically connected to the peripheral circuits PTR through the peripheral contact plugs PCP.

For example, widths of the peripheral contact plugs PCP may increase in the first direction D1 or the second direction D2 toward the third direction D3. The peripheral contact plugs PCP and peripheral circuit wirings PLP may include a conductive material such as metal.

Peripheral interlayer insulating layers 210 and 220 may be provided on the upper surface of the semiconductor substrate 200. The peripheral interlayer insulating layers 210 and 220 may cover or overlap the peripheral circuits PTR, peripheral contact plugs PCP, and peripheral circuit wirings PLP on the semiconductor substrate 200. The peripheral contact plugs PCP and the peripheral circuit wirings PLP may be electrically connected to the peripheral circuits PTR. The peripheral interlayer insulating layers 210 and 220 may include a silicon oxide layer, a silicon nitride layer, a silicon oxynitride layer, and/or a low-k dielectric layer. A low-k dielectric may for example be a material with a dielectric constant k smaller than that of silicon dioxide.

First bonding pads BP1 may be disposed in an uppermost peripheral interlayer insulating layer 220. The peripheral interlayer insulating layer 220 may not cover or may not overlap the upper surfaces of the first bonding pads BP 1. An upper surface of the uppermost peripheral interlayer insulating layer 220 may be substantially coplanar with upper surfaces of the first bonding pads BP1. The first bonding pads BP1 may be electrically connected to the peripheral circuits PTR through the peripheral circuit wirings PLP and the peripheral contact plugs PCP.

The cell array structure CS may be provided on the peripheral circuit structure PS. The cell array structure CS may include a memory cell array including memory cells three-dimensionally arranged on the substrate 100. The memory cell array may be electrically connected to second bonding pads BP2. The second bonding pads BP2 may be electrically and physically connected to the first bonding pads BP1 by a bonding manner. That is, the second bonding pads BP2 may be in direct contact with the first bonding pads BP1.

The second bonding pads BP2 may include the same metal material as the first bonding pads BP1. The second bonding pads BP2 may have substantially the same shape, width, or area as the first bonding pads BP1.

As described with reference to FIGS. 1A, 1B, 2A, and 2B, the cell array structure CS may include the stacked structure ST, the vertical structures VC, the bit lines BL, the contact plugs CP1 to CP6, the inner and outer supporters IS and OS, and an input/output contact plug IOPLG.

A plurality of stacked structures ST of the cell array structure CS may be provided. The plurality of stacked structures ST may extend in the first direction D1 and may be spaced apart from each other in the second direction D2. Hereinafter, for convenience of description, a single stacked structure ST will be described, but the following description may be equally applied to other stacked structures ST.

The stacked structure ST may include conductive patterns GE and insulating layers ILD alternately stacked along the third direction D3 (i.e., a vertical direction) perpendicular to first and second directions D1 and D2 crossing each other.

As described above, in the connection region CNR, the contact plugs CP1 to CP6 may penetrate the stacked structure ST and be connected to the conductive patterns GE, respectively.

The input/output contact plugs IOPLG may be electrically connected to an input/output pad by penetrating a flat insulating layer 120 in the connection region CNR.

A second interlayer insulating layer 130 may be disposed on the first interlayer insulating layer 110, and upper conductive lines UCL may be disposed on the second interlayer insulating layer 130. The upper conductive lines UCL may be electrically connected to bit lines BL or connection lines CL.

Third and fourth interlayer insulating layers 140 and 150 may be disposed on the second interlayer insulating layer 130, and the second bonding pads BP2 may be disposed in the fourth interlayer insulating layer 150, that is, an uppermost interlayer insulating layer. The second bonding pads BP2 may be electrically connected to upper conductive lines UCL. The second bonding pads BP2 may be formed of aluminum, copper, or tungsten.

The second bonding pads BP2 may be electrically and physically connected to the first bonding pads BP1 by a bonding manner. That is, the second bonding pads BP2 may be in direct contact with the first bonding pads BP1.

The second bonding pads BP2 may include the same metal material as the first bonding pads BP1. The second bonding pads BP2 may have substantially the same shape, width, or area as the first bonding pads BP1.

An upper insulating layer 300 may cover or overlap the substrate 100. The input/output pads PAD may be disposed on the upper insulating layer 300. A capping insulating layer 320 may be disposed on the upper insulating layer 300, and the capping insulating layer 320 may cover or overlap the input/output pads PAD.

Capping insulating layers 320 and 330 and a passivation layer 340 may be sequentially formed on the entire surface of the upper insulating layer 300. The capping insulating layers 320 and 330 may be, for example, a silicon nitride layer or a silicon oxynitride layer. The passivation layer 340 may be, for example, a polyimide-based material such as photo sensitive polyimide (PSPI).

The capping insulating layers 320 and 330 and the passivation layer 340 may have pad openings OP exposing portions of the input/output pads PAD.

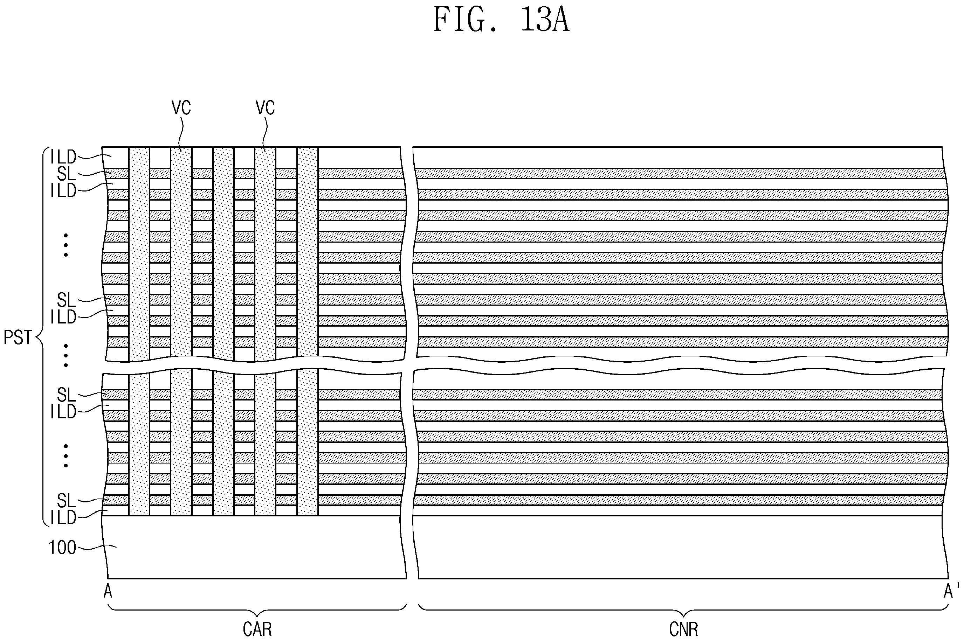

FIGS. 13A, 14A, 15A, 16A, 17A, 18A, 19A, 20A, and 21A are views for illustrating a method of manufacturing a semiconductor device according to some example embodiments of the present disclosure, and illustrate cross-sections taken along the line A-A' of FIG. 5.

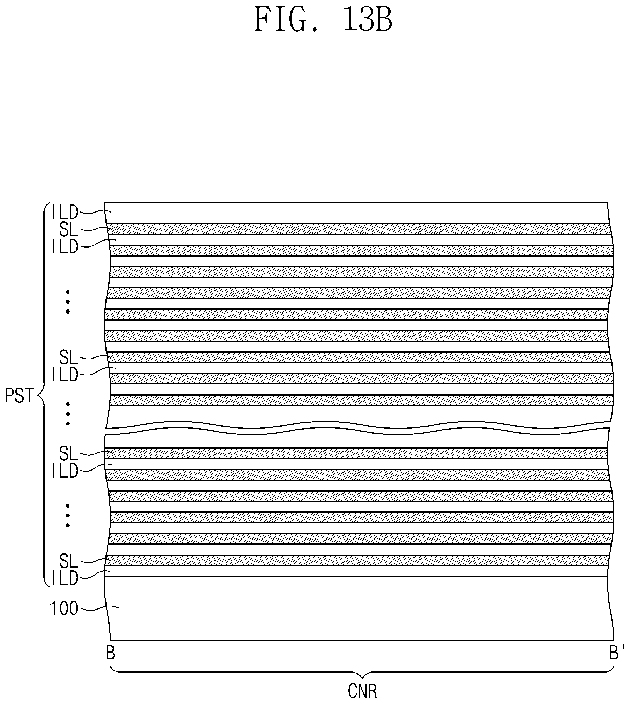

FIGS. 13B, 14B, 15B, 16B, 17B, 18B, 19B, 20B, and 21B are views for illustrating a method of manufacturing a semiconductor device according to some example embodiments of the present disclosure, and illustrate cross-sections taken along line B-B' of FIG. 5.

Referring to FIGS. 13A and 13B, a substrate 100 may include a cell array region CAR and a connection region CNR adjacent to the cell array region CAR.

The substrate 100 may include, for example, at least one of silicon (Si), germanium (Ge), silicon germanium (SiGe), gallium arsenide (GaAs), indium gallium arsenide (InGaAs), aluminum gallium arsenide (AlGaAs), or a mixture thereof. The substrate 100 may include a semiconductor doped with impurities and/or an intrinsic semiconductor in which impurities are not doped. The substrate 100 may have a crystal structure including at least one selected from single crystal, amorphous, and/or polycrystalline.

A mold structure PST in which insulating layers ILD and sacrificial layers SL are vertically alternately stacked may be formed on the substrate 100.

The mold structure PST may have a uniform thickness on the cell array region CAR and the connection region CNR. The sacrificial layers SL may have substantially the same thickness, and some of the insulating layers ILD may have different thicknesses.

In the mold structure PST, the sacrificial layers SL may be formed of a material that has etch selectivity with respect to the insulating layers ILD and may be etched. For example, the sacrificial layers SL may be formed of an insulating material different from that of the insulating layers ILD. For example, the sacrificial layers SL may be formed of a silicon nitride layer, and the insulating layers ILD may be formed of a silicon oxide layer.

The insulating layers ILD and the sacrificial layers SL may be formed by a thermal CVD process, a plasma enhanced CVD process, a physical CVD process, or an atomic layer deposition ALD process.

Subsequently, vertical channel holes exposing the substrate 100 may be formed through the mold structure PST in the cell array region CAR. When the vertical sacrificial patterns (not illustrated) are formed in the mold structure PST, forming the vertical channel holes may include removing the vertical sacrificial patterns to expose the substrate 100.

Forming the vertical channel holes may include forming a hard mask pattern on the mold structure PST and anisotropic etching of the mold structure PST using the hard mask pattern as an etch mask. The upper surface of the substrate 100 may be over-etched in the anisotropic etching process for forming vertical channel holes, and thus the upper surface of the substrate 100 exposed to the vertical channel holes may be recessed to a certain depth. In addition, during the anisotropic etching process for forming vertical channel holes, the recess the depth of the substrate 100 may be various depending on positions of the vertical channel holes.

Thereafter, vertical structures VC may be formed in the vertical channel holes of the cell array region CAR.

Forming the vertical structures VC may include forming the vertical channel holes exposing the substrate 100 through the mold structure PST, sequentially depositing a data storage layer and a vertical channel layer in vertical channel holes, and etching and planarizing the data storage layer and the vertical channel layer.

The data storage layer may be deposited to a uniform thickness on bottom surfaces and inner walls of the vertical channel holes using a chemical vapor deposition (CVD) or atomic layer deposition (ALD) process. The data storage layer may include a blocking insulating layer, a charge storage layer, and a tunneling insulating layer sequentially stacked in vertical channel holes. The vertical channel layer may be deposited to a uniform thickness on the data storage layer using a chemical vapor deposition (CVD) or atomic layer deposition (ALD) process. After forming the data storage layer and the vertical channel layer, the vertical channel holes may be filled with a gap-fill insulating layer. Accordingly, as described above with reference to FIG. 3A, the data storage pattern DSP, the vertical semiconductor pattern VP, and the gap-fill insulating pattern VI may be formed in each vertical channel hole. In addition, bit line conductive pads may be formed on upper ends of the vertical semiconductor patterns VP. The bit line conductive pads may be impurity regions doped with impurities or may be formed of a conductive material.

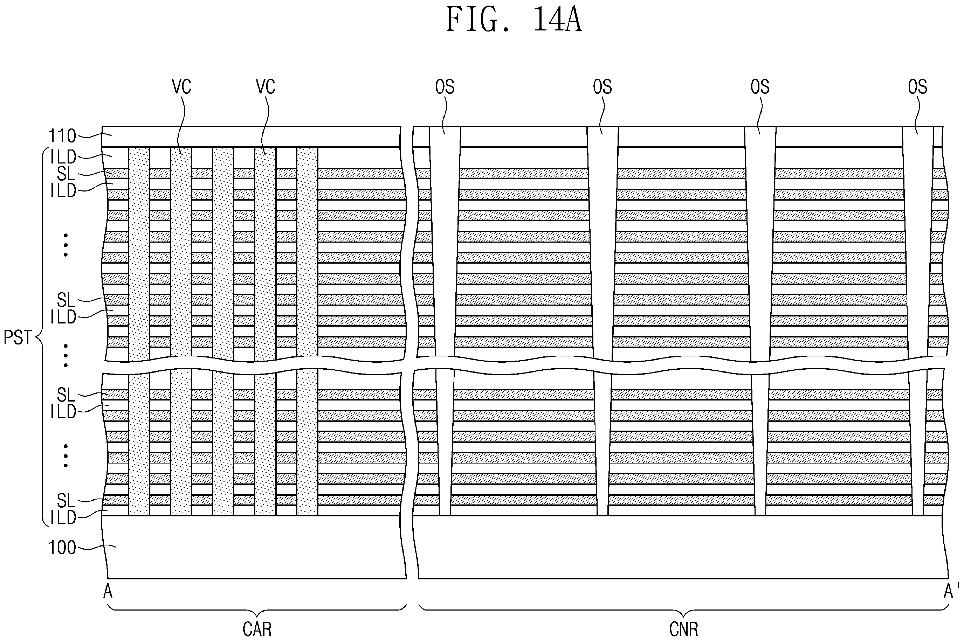

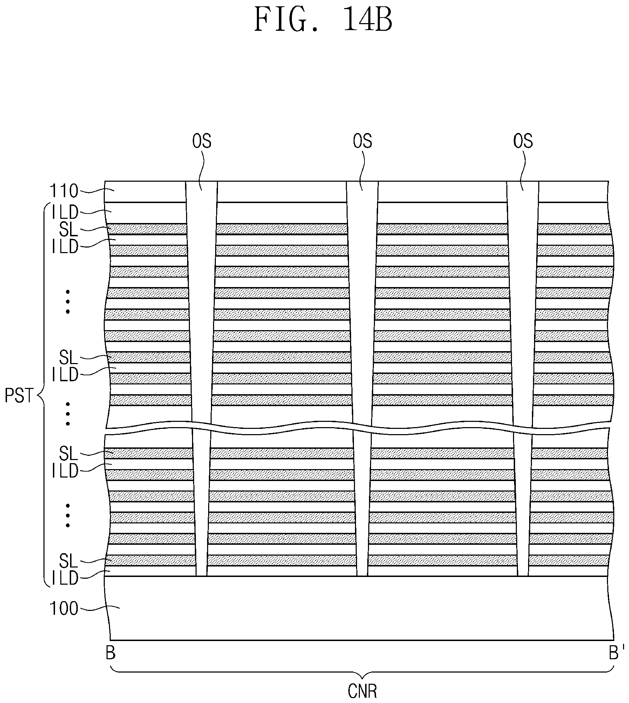

Referring to FIGS. 14A and 14B, a first interlayer insulating layer 110 may be formed on the mold structure PST. The first interlayer insulating layer 110 may cover or overlap upper surfaces of the vertical structures VC.

Subsequently, outer supporters OS penetrating the mold structure PST may be formed in the connection region CNR.

Forming the outer supporters OS may include forming a mask pattern (not shown) on the first interlayer insulating layer, anisotropically etching the mold structure PST using a mask pattern (not shown) as an etch mask to form vertical holes exposing the substrate 100, and filling of insulating material in vertical holes.

As the above-described embodiments, the outer supporters OS may be spaced apart from each other in the first and second directions D1 and D2 when viewed in a plan view, and may have different shapes and sizes.

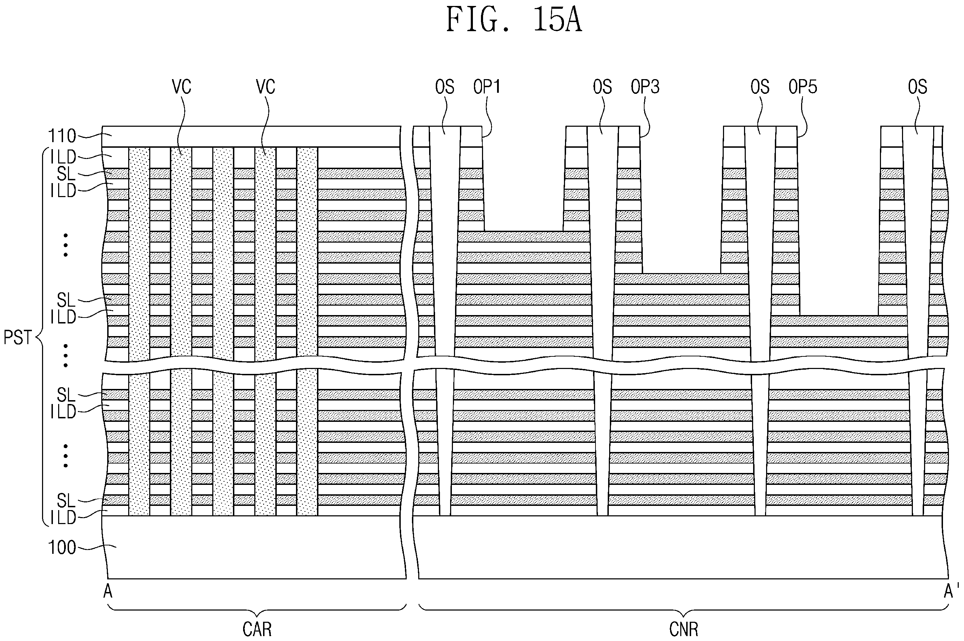

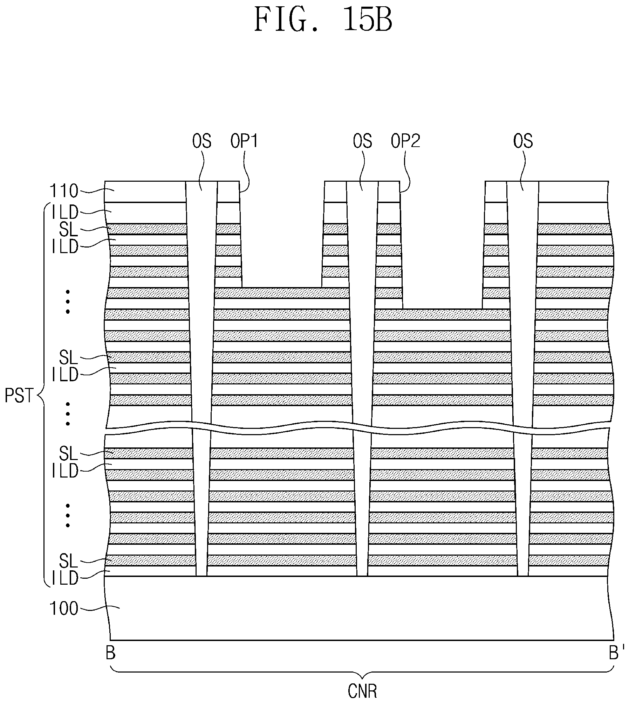

Referring to FIGS. 15A and 15B, contact holes OP1, OP2, OP3, and OP5 penetrating portions of the mold structure PST may be formed in the connection region CNR. The contact holes OP1, OP3, and OP5 may expose upper surfaces of the sacrificial layers SL positioned at different levels. Some of the sidewalls of the sacrificial layers SL and some of the sidewalls of the insulating layers ILD may be exposed by the contact holes OP1, OP2, OP3, and OP5.

The contact holes OP1, OP2, OP3, and OP5 may be formed between the outer supporters OS adjacent to each other in the first direction D1 and between the outer supporters OS adjacent to each other in the second direction D2.

Each of the contact holes OP1, OP2, OP3, and OP5 may have a lower width smaller than an upper width. Each of the contact holes OP1, OP2, OP3, and OP5 may be formed in a circular shape, a bar shape, an elliptical shape, or a polygonal shape when viewed in a plan view.

According to some example embodiments, the contact holes OP1, OP2, OP3, and OP5 may have different vertical depths. That is, the sacrificial layers SL exposed by the contact holes OP1, OP2, OP3, and OP5 may be positioned at different levels. In other words, the number of sacrificial layers SL through which the contact holes OP1, OP2, OP3, and OP5 pass may be different from each other.

The contact holes OP1, OP2, OP3, and OP5 having different vertical depths may formed by repeating mask formation processes and mold structure etching processes a plurality of times. The contact holes OP1, OP2, OP3, and OP5 may be formed by different numbers of anisotropic etching processes.

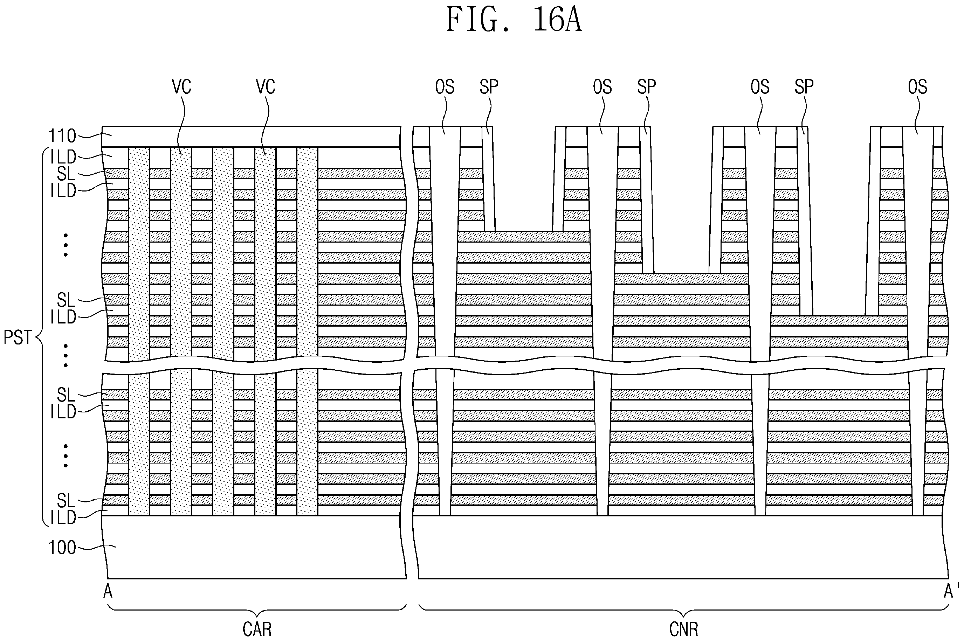

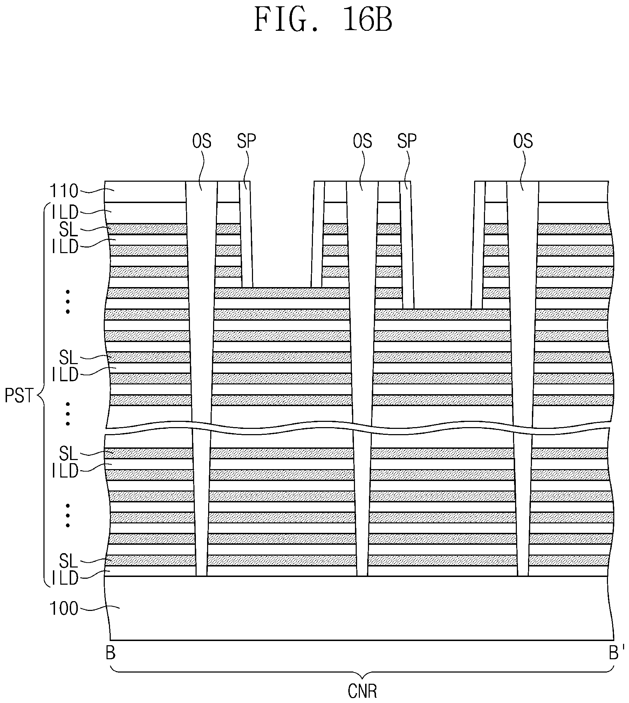

Referring to FIGS. 16A and 16B, insulating spacers SP may be formed to cover inner walls of the contact holes OP1, OP2, OP3, and OP5. The insulating spacers SP may cover or overlap sidewalls of the sacrificial layers SL and the insulating layers ILD exposed through the contact holes. The insulating spacers SP may have different vertical lengths within the contact holes.

The insulating spacers SP may include an insulating material having etch selectivity with respect to the sacrificial layers. The insulating spacers SP may include, for example, silicon oxide, silicon oxynitride, and/or a low-k material.

Forming the insulating spacers SP may include depositing a spacer layer with a uniform thickness on a mold structure having contact holes and anisotropically etching the spacer layer to expose the upper surface of the sacrificial layer SL in each contact hole.

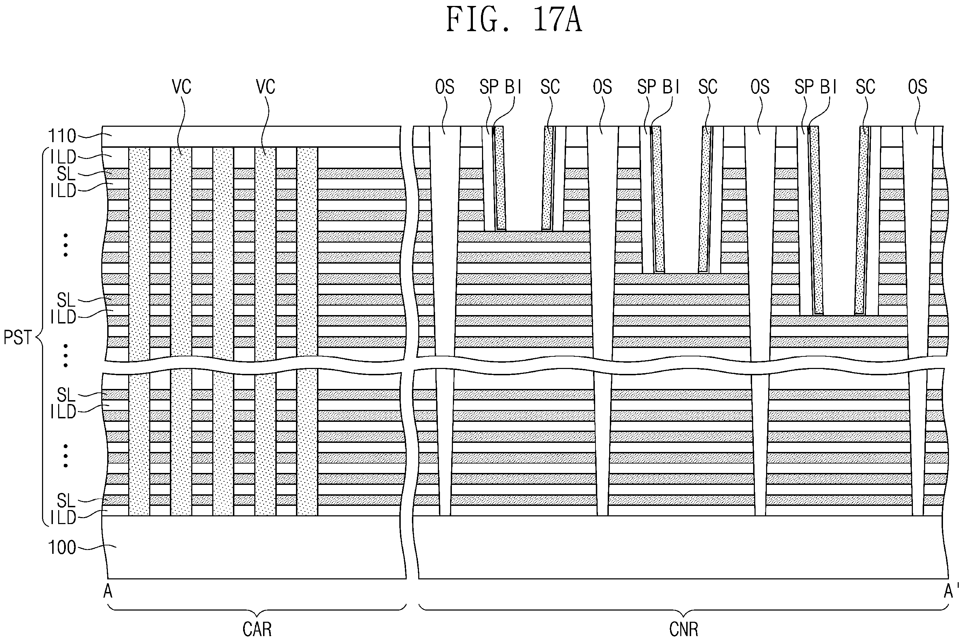

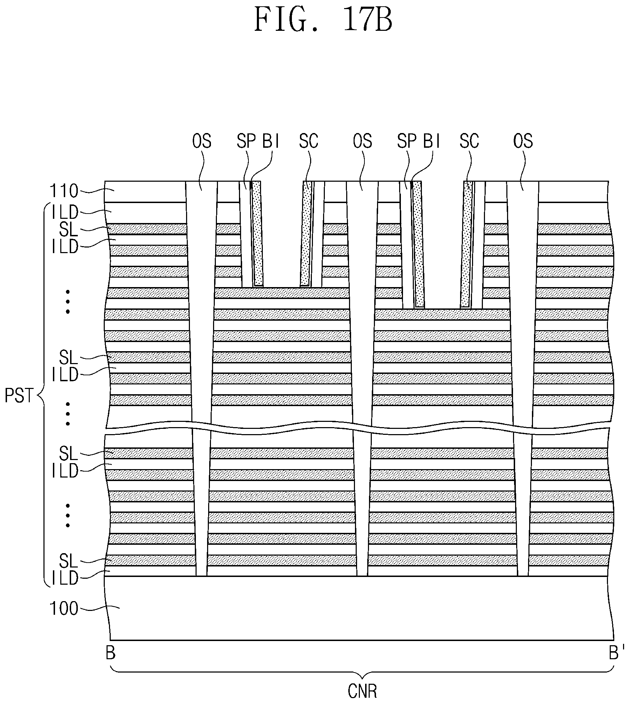

Referring to FIGS. 17A and 17B, a buffer spacer BI and a sacrificial spacer SC may be formed in each contact hole.

Forming the buffer spacer BI and the sacrificial spacer SC may include sequentially depositing a buffer layer and a sacrificial spacer layer in the contact holes in which insulating spacers are formed, and sequentially anisotropically etching the buffer layer and the sacrificial spacer layer exposing the upper surface of the sacrificial layer SL in the contact hole.

In some embodiments, a sum of thicknesses of the insulating spacer SP, the buffer spacer BI, and the sacrificial spacer SC may be less than 1/2 of a diameter of each contact hole.

The buffer spacer BI may be formed of a material having etch selectivity with respect to the sacrificial layers SL. The buffer spacer BI may include the same insulating material as the insulating spacer SP. For example, the buffer spacer BI may include a silicon oxide layer. The buffer spacer BI may be formed between a bottom surface of the sacrificial spacer SC and an upper surface of the sacrificial layer SL and between the insulating spacer SP and the sacrificial spacer SC. The sacrificial spacers SC in the contact holes may have different vertical lengths.

The sacrificial spacer SC may be formed of a material having etch selectivity with respect to the buffer spacer BI. The sacrificial spacer SC may include, for example, silicon nitride or silicon oxynitride.

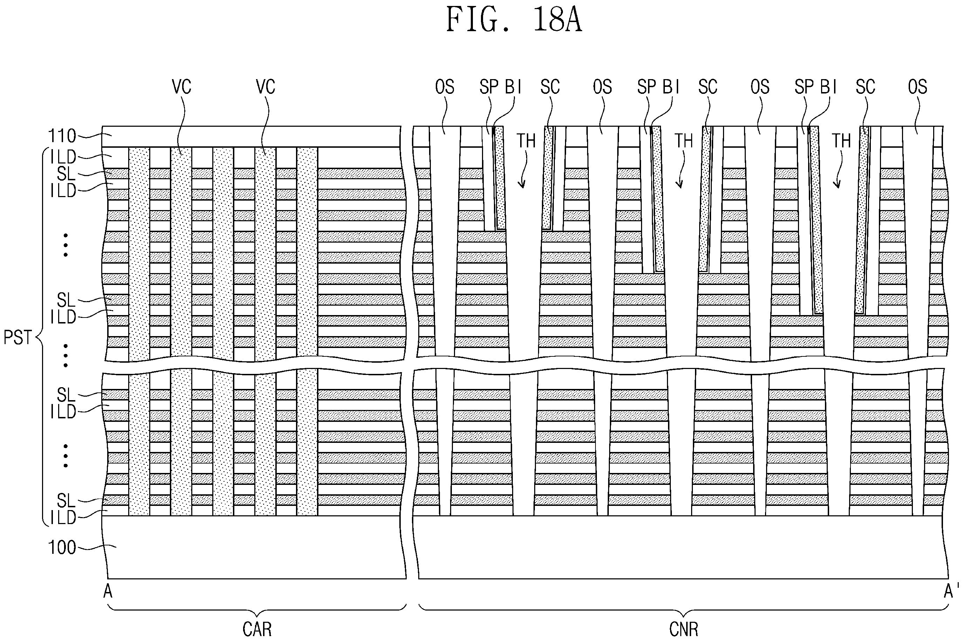

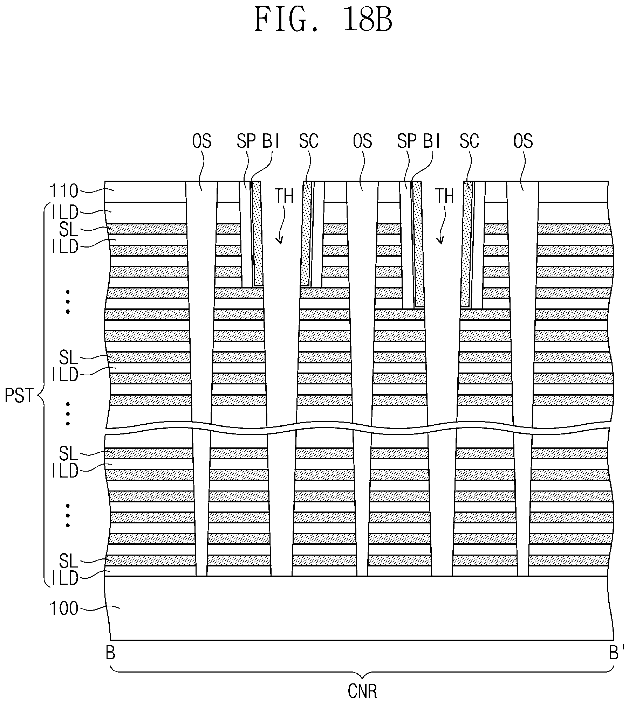

Referring to FIGS. 18A and 18B, through holes TH penetrating the mold structure PST may be formed in each contact hole.

Forming the through holes TH may include anisotropically etching the mold structure PST using the sacrificial spacer SC as an etch mask. The through holes TH may expose the substrate 100.

The through holes TH in the contact holes may have substantially the same vertical depth. Each of the through holes TH may have a lower width smaller than an upper width.

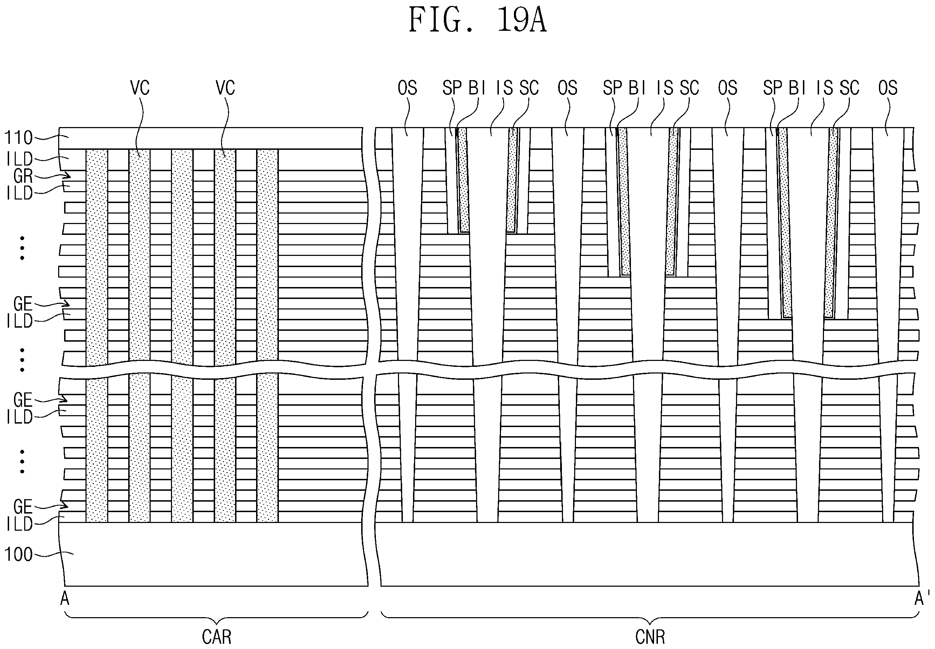

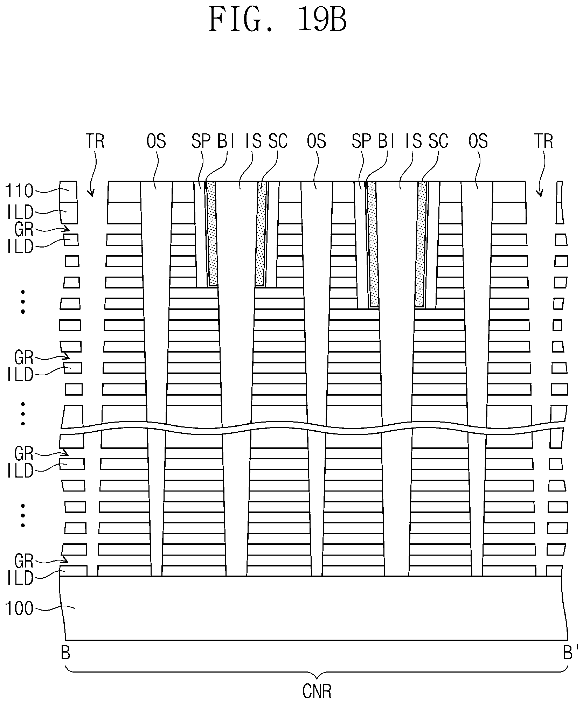

Thereafter, referring to FIGS. 19A and 19B, the through holes TH may be filled with an insulating material to form inner supporters IS. An insulating layer may be deposited on the mold structure PST in which the through holes TH and then the insulating layer may be planarized to expose an upper surface of the first interlayer insulating layer 110, thereby forming inner supporters IS.

As each of the inner and outer supporters IS and OS has a smaller lower width than an upper width, a distance between the inner and outer supporters IS and OS adjacent to each other may be greater in the lower portion thereof than in the upper portion thereof.

After forming the inner supporters IS, the mold structure PST may be patterned to form separation trenches TR extending in the first direction D 1. The separation trenches TR may expose the substrate 100. Accordingly, the mold structure PST may be patterned in a line shape extending in the first direction D1.

Then, the sacrificial layers SL exposed in the separation trenches TR may be removed to form gate regions GR between the insulating layers ILD. The gate regions GR may be formed by isotropically etching the sacrificial layers SL using an etching recipe having etch selectivity for the insulating layers ILD, the vertical structures VC, and the inner and outer supports OS and IS. The gate regions GR formed as described above may extend horizontally from the separation trenches TR. In addition, the gate regions GR may expose portions of the vertical structures VC in the cell array region CAR and may expose portions of the inner and outer supporters OS and IS and portions of the insulating spacers in the connection region CNR.

While forming the gate regions GR, the inner and outer supporters IS and OS may prevent the vertically stacked insulating layers ILD in the connection region CNR from collapsing. According to the embodiments, as the inner supporters IS are respectively disposed between the outer supporters OS adjacent to each other, the number of stacked conductive patterns GE increases, and the diameters of the contact plugs CP1 to CP6 increase, a distance between the outer supporters OS may increase, thereby preventing the insulating layers ILD from collapsing between the outer supporters OS adjacent to each other.

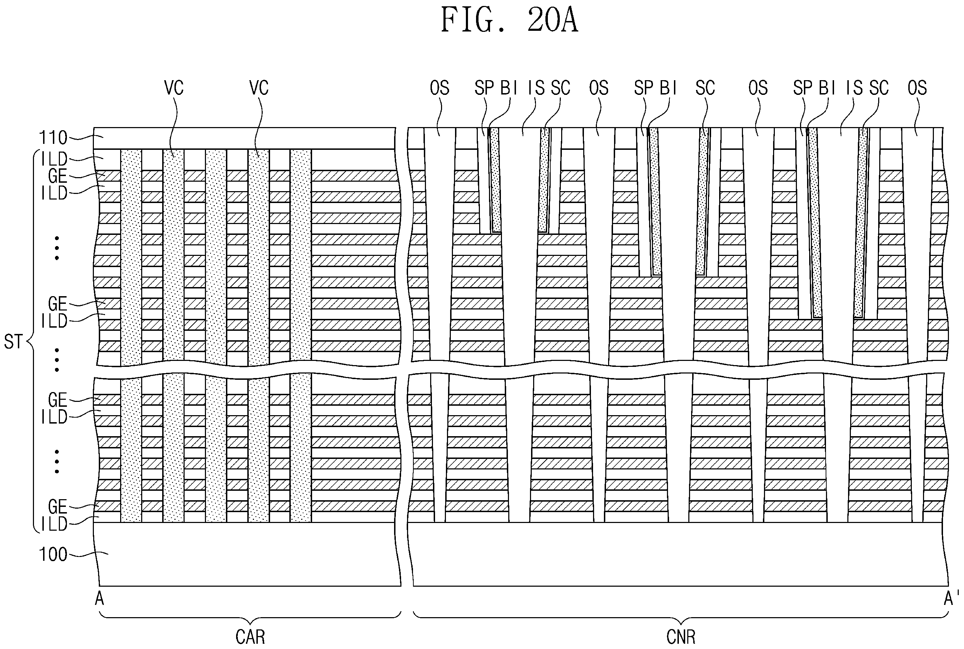

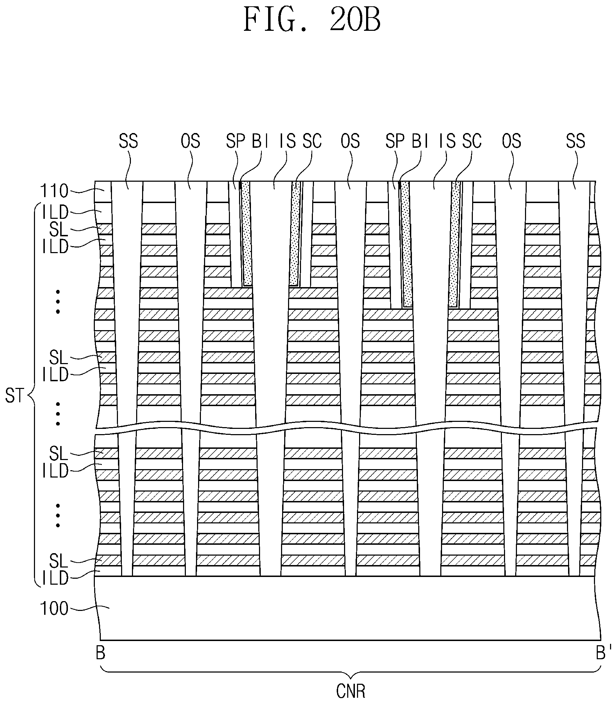

Referring to FIGS. 20A and 20B, the conductive patterns GE may be formed in the gate regions. The conductive patterns GE may partially fill the gate regions GR or completely fill the gate regions GR. In one example, the conductive patterns GE may include sequentially depositing a metal nitride layer (e.g., TiN, TaN, or WN) and a metal layer (e.g., W, Al, Ti, Ta, Co, or Cu). Subsequently, portions of the metal nitride layer and the metal layer formed in the separation trenches TR may be removed to locally form the conductive patterns GE in the gate regions GR. Accordingly, the stacked structure ST in which insulating layers ILD and conductive patterns GE are alternately stacked may be formed on the substrate 100.

According to some example embodiments of the present disclosure, before forming the conductive patterns GE, a horizontal insulating pattern HP (refer to FIGS. 3A and 3B) conformally covering or overlapping inner walls of the gate regions GR may be formed. The horizontal insulating pattern may be formed with a substantially uniform thickness on inner walls of the gate regions GR.

After forming the conductive patterns GE, the separation structures SS may be formed by filling the separation trenches TR with an insulating material.

After forming the separation structures SS, a process of replacing the sacrificial spacers SC with contact plugs CP may be performed in the connection region CNR.

In detail, an isotropic etching process to remove the sacrificial spacers SC may be performed to form recessed regions between the insulating spacers SP and the inner supporters IS. During the isotropic etching process on the sacrificial spacers SC, the buffer spacers BI may be used as an etch stop layer. Subsequently, portions of the horizontal insulating patterns on upper surfaces of the buffer spacers BI and the conductive patterns GE may be etched. Accordingly, upper surfaces of the conductive patterns GE may be exposed in the recess regions.

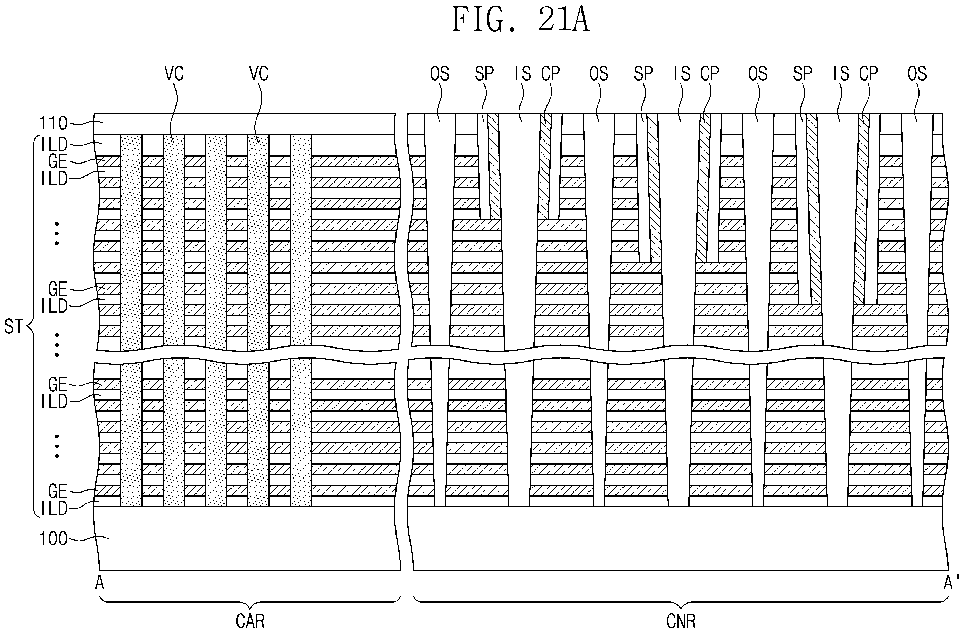

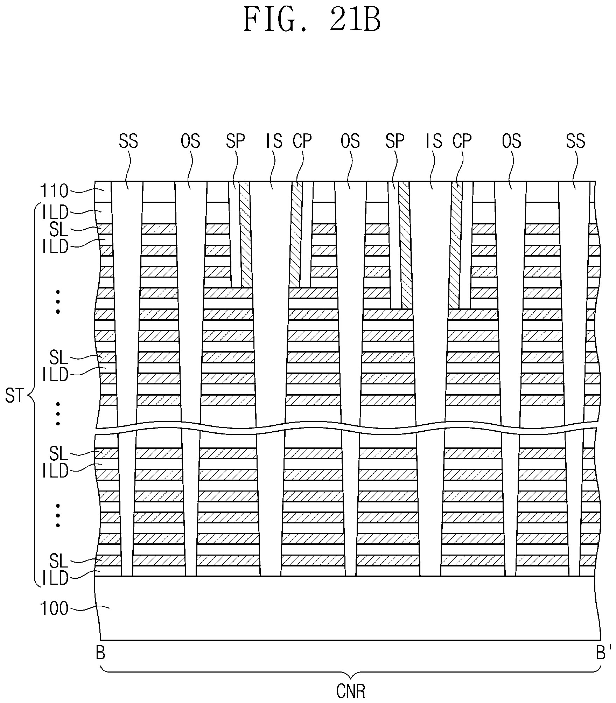

Then, contact plugs CP connected to the conductive patterns GE may be formed by filling the recess regions with a conductive material, as illustrated in FIGS. 21A and 21B.

In detail, referring to FIGS. 21A and 21B, forming the contact plugs CP1 to CP6 may include depositing a conductive layer filling the recess regions on the first interlayer insulating layer 110 and planarizing the conductive layer to expose the first interlayer insulating layer 110.

That is, upper surfaces of the contact plugs CP1 to CP6 may be coplanar with the upper surface of the first interlayer insulating layer 110. The contact plugs CP1 to CP6 may have different vertical lengths and may be in contact with the upper surfaces of the conductive patterns GE, respectively.

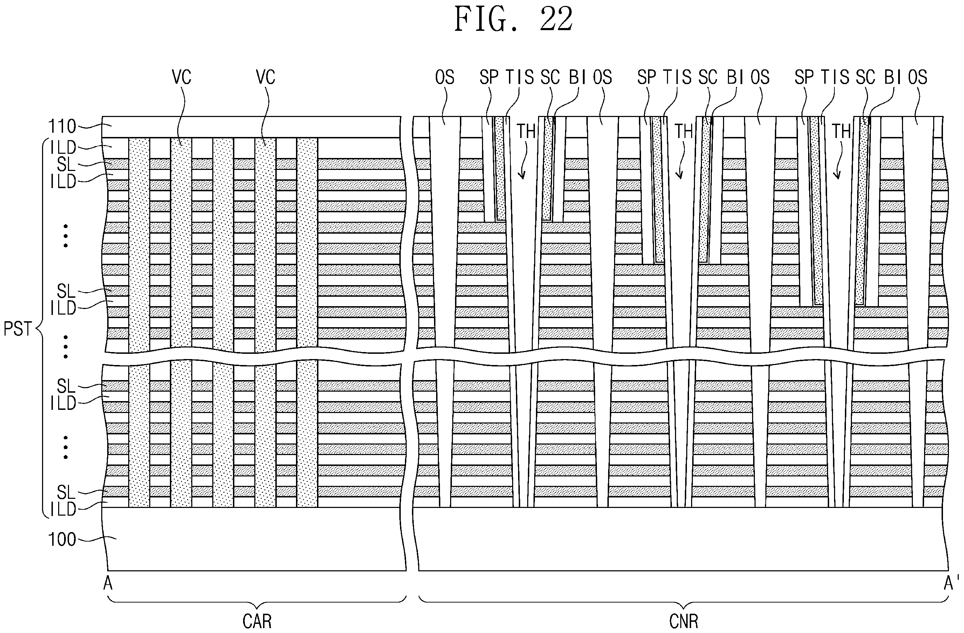

FIGS. 22 to 25 are views for illustrating a method of manufacturing a semiconductor device according to some example embodiments of the present disclosure, and illustrate cross-sections taken along line A-A' of FIG. 5.

Referring to FIG. 22, as described with reference to FIGS. 18A and 18B, through holes TH exposing the substrate 100 may be formed by penetrating the mold structure PST in the connection region CNR, and then a through insulating spacer TIS may be formed in the through hole TH.

Forming the through insulating spacer TIS may include depositing a spacer layer with a uniform thickness on the mold structure PST in which through holes TH are formed and anisotropically etching the spacer layer to expose the upper surface of the substrate 100 in each through hole TH. Here, a thickness of the spacer layer may be less than about 1/2 of the diameter of each through hole TH. The through insulating spacer TIS may include, for example, silicon oxide, silicon oxynitride, and/or a low-k material.

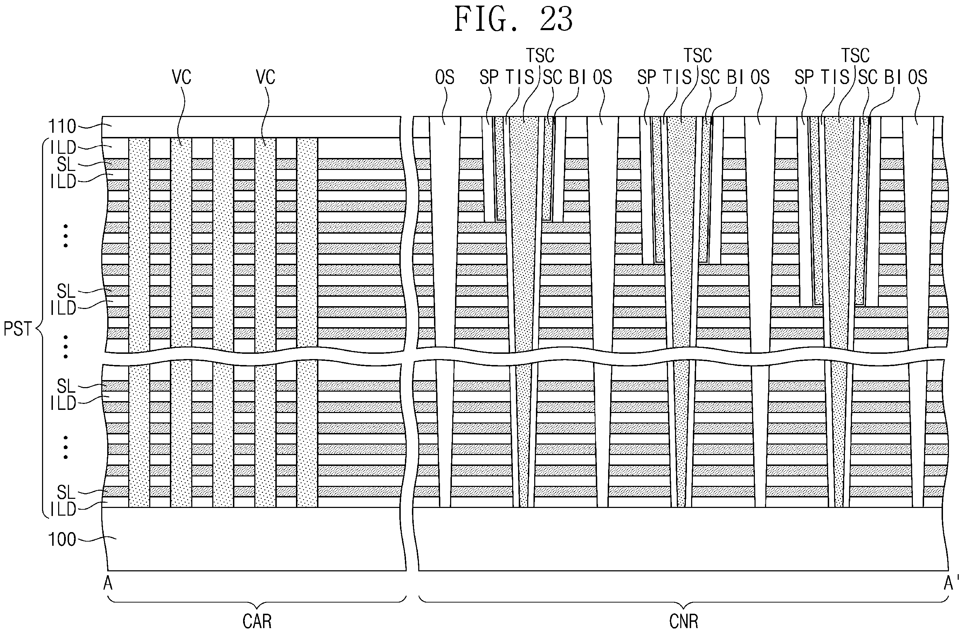

Referring to FIG. 23, through sacrificial spacers TSC may be formed in through holes TH in which through insulating spacers TIS are formed. Forming the through sacrificial spacers TSC may include depositing a sacrificial spacer layer to fill the through holes TH in which the through insulating spacers TIS are formed, and planarizing the sacrificial spacer layer to expose the first interlayer insulating layer 110.

The through sacrificial spacer TSC may be formed of a material having etch selectivity with respect to the through insulating spacer TIS. The through sacrificial spacer TSC may be formed of the same material as the sacrificial spacers SC. The through sacrificial spacer TSC may include, for example, silicon nitride or silicon oxynitride.

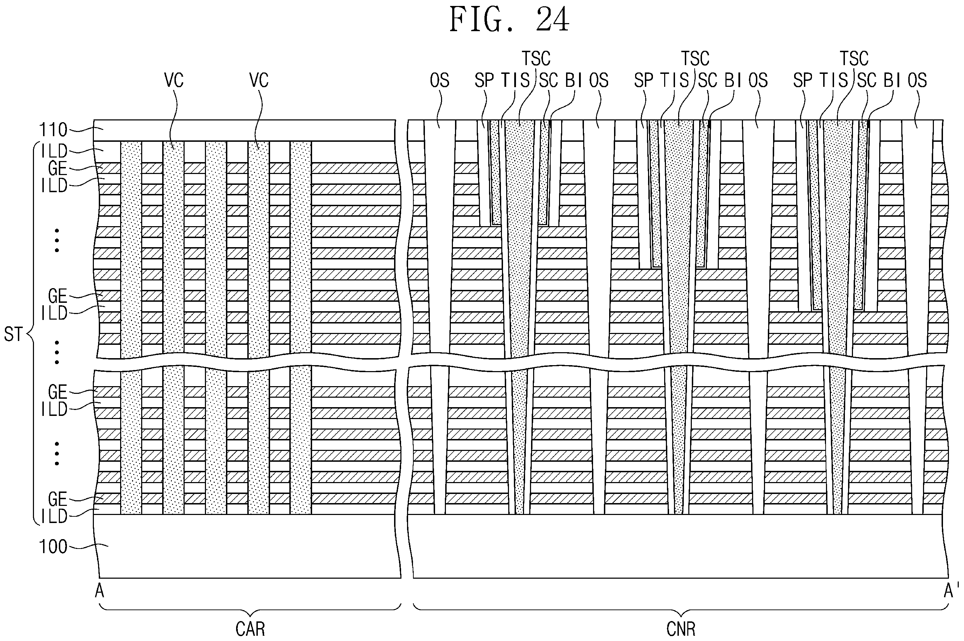

Referring to FIG. 24, after forming the through insulating spacers TIS and the through sacrificial spacers TSC, as described with reference to FIGS. 19A, 19B, 20A, and 20B the sacrificial layers SL of the mold structure PST may be replaced with conductive patterns GE. Accordingly, a stacked structure ST may be formed on the substrate 100.

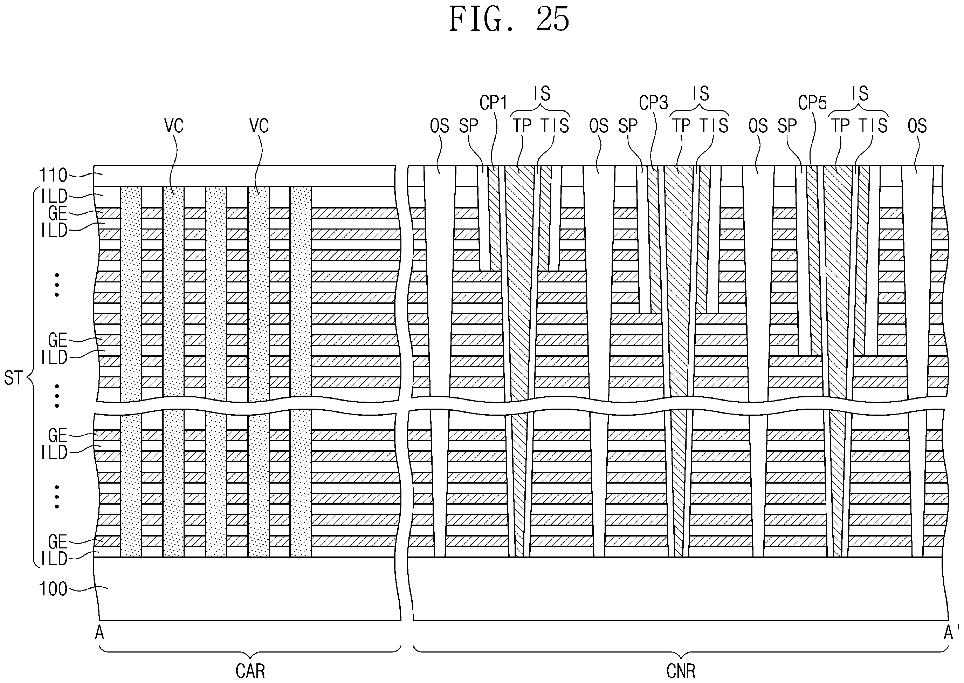

Referring to FIG. 25, replacing the sacrificial spacers SC with contact plugs CP1 to CP6 and replacing the through sacrificial spacers TSC with through conductive plugs TP may be performed.

In detail, an isotropic etching process may be performed to remove the sacrificial spacers SC and the penetrating sacrificial spacers TSC to form recess regions between the insulating spacers SP and the inner supporters IS while the through insulating spacers TIS in the through holes TH may be exposed.

Subsequently, a conductive layer filling the through-holes in which the recess regions and the insulating spacers SP are formed may be deposited on the first interlayer insulating layer 110 and then the conductive layer may be planarized to expose the first interlayer insulating layer 110. Accordingly, contact plugs CP1 to CP6 and through conductive plugs TP may be formed.

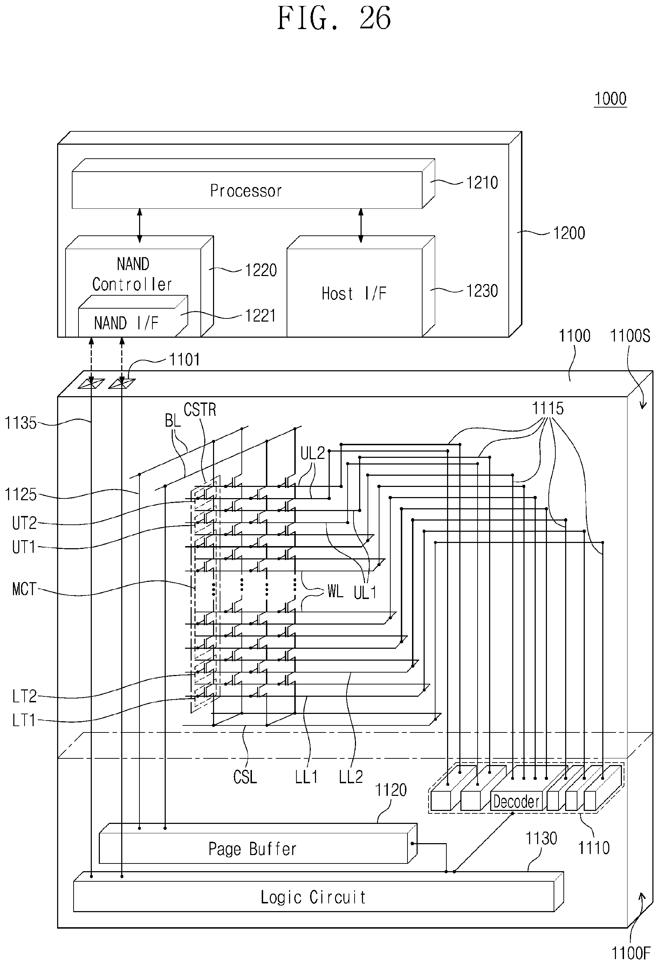

FIG. 26 is a diagram schematically illustrating an electronic system including a semiconductor device according to some example embodiments of the present disclosure.

Referring to FIG. 26, an electronic system 1000 according to some embodiments of the inventive concepts may include a semiconductor device 1100 and a controller 1200 electrically connected to the semiconductor device 1100. The electronic system 1000 may be a storage device including one or more semiconductor devices 1100 or an electronic device including the storage device. For example, the electronic system 1000 may be a solid state drive (SSD) device, a universal serial bus (USB), a computing system, a medical system, or a communication system, in which at least one semiconductor device 1100 is provided.

The semiconductor device 1100 may be a nonvolatile memory device (e.g., a NAND FLASH memory device). The semiconductor device 1100 may include a first structure 1100F and a second structure 1100S on the first structure 1100F. In some embodiments, the first structure 1100F may be disposed beside the second structure 1100S.

The first structure 1100F may be a peripheral circuit structure including a decoder circuit 1110, a page buffer circuit 1120, and a logic circuit 1130. The second structure 1100S may be a memory cell structure (e.g., a cell array structure according to any of the embodiments) including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of the lower transistors LT1 and LT2 and the number of the upper transistors UT1 and UT2 may be variously changed, according to embodiments.

In some embodiments, the upper transistors UT1 and UT2 may include at least one string selection transistor, and the lower transistors LT1 and LT2 may include at least one ground selection transistor. The gate lower lines LL1 and LL2 may be respectively used as gate electrodes of the lower transistors LT1 and LT2. The word lines WL may be respectively used as gate electrodes of the memory cell transistors MCT, and the gate upper lines UL1 and UL2 may be respectively used as gate electrodes of the upper transistors UT1 and UT2.

In some embodiments, the lower transistors LT1 and LT2 may include a lower erase control transistor LT1 and a ground selection transistor LT2, which are connected in series. The upper transistors UT1 and UT2 may include a string selection transistor UT1 and an upper erase control transistor UT2, which are connected in series. At least one of the lower and upper erase control transistors LT1 and UT2 may be used for an erase operation of erasing data, which are stored in the memory cell transistors MCT, using a gate-induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first connection lines 1115, which are extended from the first structure 1100F into the second structure 1100S. The bit lines BL may be electrically connected to the page buffer circuit 1120 through second connection lines 1125, which are extended from the first structure 1100F to the second structure 1100S.

In the first structure 1100F, the decoder circuit 1110 and the page buffer circuit 1120 may be configured to perform a control operation on at least selected one of the memory cell transistors MCT. The decoder circuit 1110 and the page buffer circuit 1120 may be controlled by the logic circuit 1130. The semiconductor device 1100 may communicate with the controller 1200 through an input/output pad 1101, which is electrically connected to the logic circuit 1130. The input/output pad 1101 may be electrically connected to the logic circuit 1130 through an input/output connection line 1135, which is extended from the first structure 1100F to the second structure 1100S.

Although not illustrated in the drawing, the first structure 1100F may include a voltage generator (not illustrated). The voltage generator may generate a program voltage, a read voltage, a pass voltage, a verify voltage, and the like necessary for operating the memory cell strings CSTR. Here, the program voltage may be a relatively high voltage (e.g., 20V to 40V) compared to the read voltage, the pass voltage, and the verify voltage.

In some embodiments, the first structure 1100F may include high voltage transistors and low voltage transistors. The decoder circuit 1110 may include pass transistors connected to the word lines WL of the memory cell strings CSTR. The pass transistors may include high voltage transistors capable of withstanding a high voltage, such as a program voltage applied to the word lines WL during a program operation. The page buffer circuit 1120 may also include high voltage transistors capable of withstanding high voltage.

The controller 1200 may include a processor 1210, a NAND controller 1220, and a host interface 1230. In some embodiments, the electronic system 1000 may include a plurality of semiconductor devices 1100, and in this case, the controller 1200 may control the semiconductor devices 1100.

The processor 1210 may control overall operations the electronic system 1000 including the controller 1200. The processor 1210 may be operated based on a specific firmware and may control the NAND controller 1220 to access the semiconductor device 1100. The NAND controller 1220 may include a NAND interface 1221, which is used to communicate with the semiconductor device 1100. The NAND interface 1221 may be configured to transmit and receive control commands, which are used to control the semiconductor device 1100, data, which are written in or read from the memory cell transistors MCT of the semiconductor device 1100, and so forth. The host interface 1230 may be configured to allow for communication between the electronic system 1000 and an external host. When the processor 1210 receives a control command transmitted from the external host through the host interface 1230, the processor 1210 may control the semiconductor device 1100 in response to the control command.

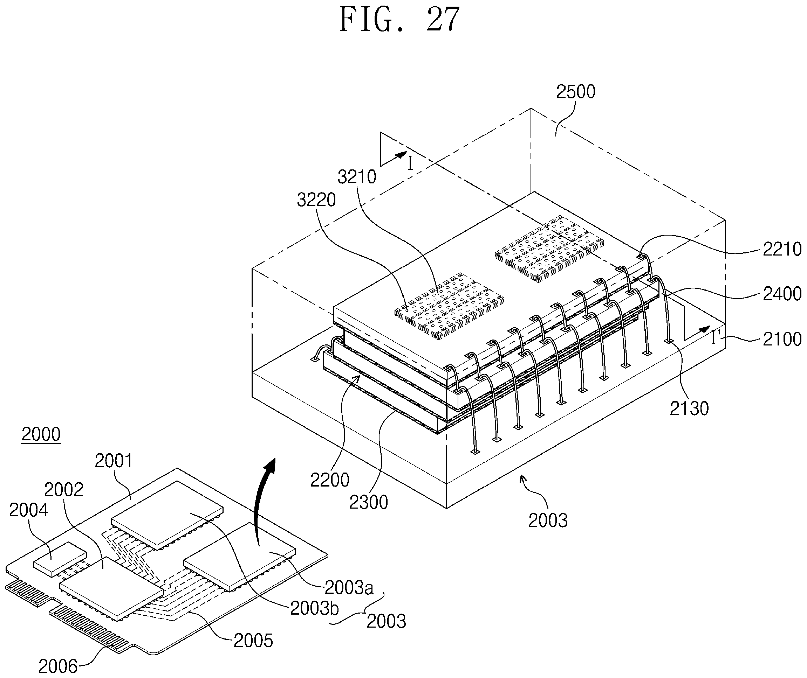

FIG. 27 is a schematic perspective view of an electronic system including a semiconductor device according to some example embodiments of the present disclosure.

Referring to FIG. 27, an electronic system 2000 according to some embodiments of the inventive concepts may include a main substrate 2001 and a controller 2002, at least one semiconductor package 2003, and a DRAM 2004, which are mounted on the main substrate 2001. The semiconductor package 2003 and the DRAM 2004 may be connected to the controller 2002 by interconnection patterns 2005, which are formed in the main substrate 2001.

The main substrate 2001 may include a connector 2006, which includes a plurality of pins coupled to an external host. In the connector 2006, the number and arrangement of the pins may be changed depending on a communication interface between the electronic system 2000 and the external host. In some embodiments, the electronic system 2000 may communicate with the external host, in accordance with one of interfaces, such as universal serial bus (USB), peripheral component interconnect express (PCI-Express), serial advanced technology attachment (SATA), universal flash storage (UFS) M-Phy, or the like. In some embodiments, the electronic system 2000 may be driven by a power, which is supplied from the external host through the connector 2006. The electronic system 2000 may further include a power management integrated circuit (PMIC) that is configured to distribute a power, which is supplied from the external host, to the controller 2002 and the semiconductor package 2003.

The controller 2002 may be configured to control a writing or reading operation on the semiconductor package 2003 and to improve an operation speed of the electronic system 2000.

The DRAM 2004 may be a buffer memory, which relieves technical difficulties caused by a difference in speed between the semiconductor package 2003, which serves as a data storage device, and an external host. In some embodiments, the DRAM 2004 in the electronic system 2000 may serve as a cache memory and may be used as a storage space, which is configured to store data temporarily during a control operation on the semiconductor package 2003. In the case where the electronic system 2000 includes the DRAM 2004, the controller 2002 may further include a DRAM controller for controlling the DRAM 2004, in addition to a NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the semiconductor chips 2200 on the package substrate 2100, adhesive layers 2300 disposed on respective bottom surfaces of the semiconductor chips 2200, a connection structure 2400 electrically connecting the semiconductor chips 2200 to the package substrate 2100, and a molding layer 2500 disposed on the package substrate 2100 to cover the semiconductor chips 2200 and the connection structure 2400.

The package substrate 2100 may be a printed circuit board including package upper pads 2130. Each of the semiconductor chips 2200 may include an input/output pad 2210. The input/output pad 2210 may correspond to the input/output pad 1101 of FIG. 26. Each of the semiconductor chips 2200 may include gate stacks 3210 and vertical structures 3220. Each of the semiconductor chips 2200 may include a semiconductor device, which will be described below, according to some embodiments of the inventive concepts.

In some embodiments, the connection structure 2400 may be a bonding wire, which is provided to electrically connect the input/output pad 2210 to the package upper pads 2130. Thus, in each of the first and second semiconductor packages 2003a and 2003b, the semiconductor chips 2200 may be electrically connected to each other in a bonding wire manner and may be electrically connected to the package upper pads 2130 of the package substrate 2100. In some embodiments, in each of the first and second semiconductor packages 2003a and 2003b, the semiconductor chips 2200 may be electrically connected to each other by a connection structure including through-silicon vias (TSV), not by the connection structure 2400 provided in the form of bonding wires.

In some embodiments, the controller 2002 and the semiconductor chips 2200 may be included in a single package. In some embodiments, the controller 2002 and the semiconductor chips 2200 may be mounted on an additional interposer substrate different from the main substrate 2001 and may be connected to each other through interconnection lines, which are provided in the interposer substrate.

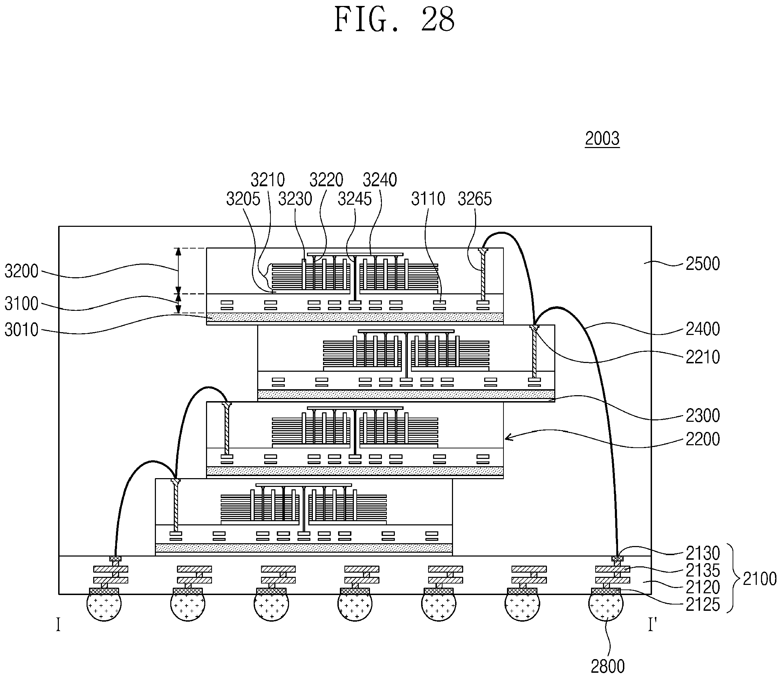

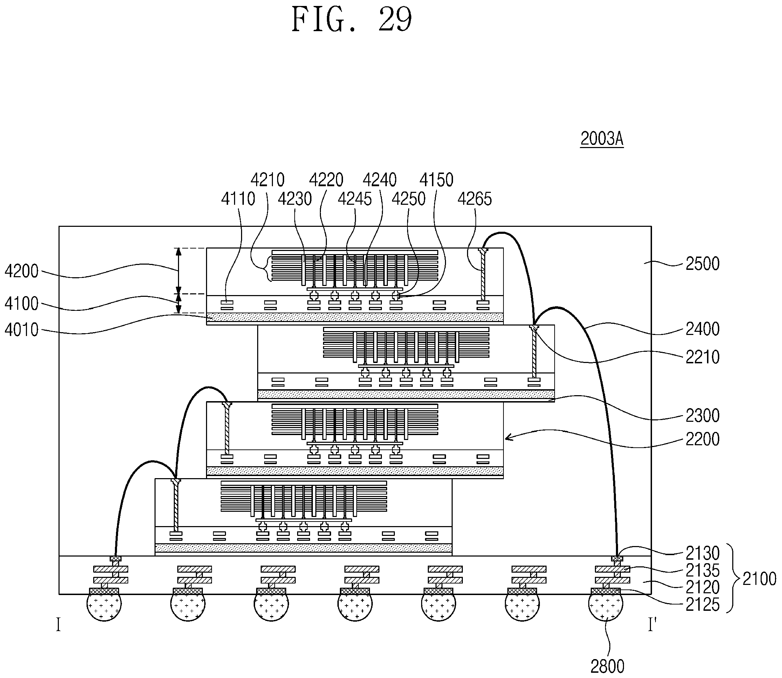

FIGS. 28 and 29 are cross-sectional views schematically illustrating semiconductor packages according to some example embodiments of the present disclosure, conceptually illustrating a region obtained by cutting the semiconductor package of FIG. 27 along the cutting line I-I'.

Referring to FIG. 28 the package substrate 2100 of the semiconductor package 2003 may be a printed circuit board. The package substrate 2100 may include a package substrate body portion 2120, the package upper pads 2130 (e.g., see FIG. 27), which are disposed on a top surface of the package substrate body portion 2120, lower pads 2125, which are disposed on or exposed through a bottom surface of the package substrate body portion 2120, and internal lines 2135, which are disposed in the package substrate body portion 2120 to electrically connect the package upper pads 2130 to the lower pads 2125. The package upper pads 2130 may be electrically connected to the connection structures 2400. The lower pads 2125 may be connected to the interconnection patterns 2005 of the main substrate 2001 of the electronic system 2000 shown in FIG. 27 through conductive connecting portions 2800.

Each of the semiconductor chips 2200 may include a semiconductor substrate 3010 and a first structure 3100 and a second structure 3200, which are sequentially stacked on the semiconductor substrate 3010.

The first structure 3100 of FIG. 28 may correspond to the peripheral circuit structure in the above-described embodiments, and the second structure 3200 of FIG. 28 may correspond to the cell array structure in the above-described embodiments.

The first structure 3100 may include a peripheral circuit region including peripheral lines 3110. The second structure 3200 may include a source structure 3205, a gate stack 3210 on the source structure 3205, the vertical structures 3220 and separation structures 3230 penetrating the gate stack 3210, bit lines 3240 electrically connected to the vertical structures 3220, junction structures 3250, and cell contact plugs 3235 electrically connected to the word lines WL (e.g., see FIG. 26) of the gate stack 3210. Each of the first and second structures 3100 and 3200 and the semiconductor chips 2200 may further include separation structures to be described below.

Each of the semiconductor chips 2200 may include a penetration line 3245, which is electrically connected to the peripheral lines 3110 of the first structure 3100 and is extended into the second structure 3200. The penetration line 3245 may be disposed outside the gate stack 3210, and in some embodiments, the penetration line 3245 may be provided to further penetrate the gate stack 3210. Each of the semiconductor chips 2200 may further include the input/output pad 2210 (e.g., see FIG. 27), which is electrically connected to the peripheral lines 3110 of the first structure 3100.

Referring to FIG. 29, in the semiconductor package 2003A, each of the semiconductor chips 2200 a may include a semiconductor substrate 4010, a first structure 4100 on the semiconductor substrate 4010, and a second structure 4200, which is provided on the first structure 4100 and is bonded to the first structure 4100 in a wafer bonding manner. The first structure 4100 of FIG. 29 may correspond to the peripheral circuit structure in the above-described embodiments, and the second structure 4200 of FIG. 29 may correspond to the cell array structure in the above-described embodiments.

The first structure 4100 may include a peripheral circuit region including a peripheral line 4110 and first junction structures 4150. The second structure 4200 may include a source structure 4205, a stack 4210 between the source structure 4205 and the first structure 4100, vertical structures 4220 and a separation structure 3230 penetrating the stack 4210, and second junction structures 4250, which are electrically and respectively connected to the vertical structures 4220 and the word lines WL (e.g., see FIG. 26) of the stack 4210. For example, the second junction structures 4250 may be electrically connected to the vertical structures 4220 and the word lines WL (e.g., see FIG. 26), respectively, through bit lines 4240 electrically connected to the vertical structures 4220 and cell contact plugs 4235 electrically connected to the word lines WL (e.g., see FIG. 26). The first junction structures 4150 of the first structure 4100 may be in contact with and bonded to the second junction structures 4250 of the second structure 4200. The bonded portions of the first junction structures 4150 and the second junction structures 4250 may be formed of or include, for example, copper (Cu).

Each of the first and second structures 4100 and 4200 and the semiconductor chips 2200 a may further include a source structure according to some embodiments to be described below. Each of the semiconductor chips 2200 a may further include the input/output pad 2210 (e.g., see FIG. 27), which is electrically connected to the peripheral lines 4110 of the first structure 4100.

The semiconductor chips 2200 of FIG. 28 or the semiconductor chips 2200 of FIG. 29 may be electrically connected to each other by the connection structures 2400, which are provided in the form of bonding wires. However, in some embodiments, semiconductor chips provided in each semiconductor package (e.g., the semiconductor chips 2200 of FIG. 28 and the semiconductor chips 2200 a of FIG. 19) may be electrically connected to each other through a connection structure including through-silicon vias (TSV).

According to the embodiments of the inventive concepts, the inner supporters may be respectively disposed between the outer supporters adjacent to each other, the distance between the outer supporters may increase as the number of stacked conductive patterns increases and the diameter of the contact plugs increases, and thus the collapsing of the insulating layers between the supporters may be prevented.

Although terms (e.g., first, second or third) may be used herein to describe various elements, these elements should not be limited by these terms. These terms are only used to distinguish one element from another. For example, a first element may be referred to as a second element, and, similarly a second element may be referred to as a first element without departing from the teachings of the disclosure.

As used herein, an element or region that is "covering" or "surrounding" or "filling" another element or region may completely or partially cover or surround or fill or overlap the other element or region. Further, "an element A connected to an element B" (or similar language) may mean that the element A is electrically connected to the element B and/or the element A contacts the element B.

While embodiments are described above, a person skilled in the art may understand that many modifications and variations are made without departing from the scope of the present disclosure defined in the following claims. Accordingly, the example embodiments of the present disclosure should be considered in all respects as illustrative and not restrictive, with the scope of the present disclosure being indicated by the appended claims.

Embodiments are set out in the following clauses:
1. A semiconductor device comprising:
   a substrate including a connection region;
   a stacked structure including conductive patterns stacked on the substrate;
   an inner supporter that extends into the stacked structure in the connection region;
   a contact plug that extends into the stacked structure and is electrically connected to one of the conductive patterns, wherein the contact plug at least partially extends around the inner supporter in plan view;
   an insulating spacer between the contact plug and the stacked structure, wherein the insulating spacer at least partially extends around the contact plug in the plan view; and
   outer supporters in the connection region, wherein the outer supporters are spaced apart from the contact plug and extend into the stacked structure.
2. The semiconductor device of clause 1, wherein the inner supporter includes a first insulating pillar and the outer supporters include respective second insulating pillars.
3. The semiconductor device of clause 1 or clause 2, wherein the inner supporter includes a through conductive plug that extends into the stacked structure, and a through insulating spacer that at least partially extends around the through conductive plug in the plan view.
4. The semiconductor device of any preceding clause, wherein the contact plug and the insulating spacer are in contact with an upper surface of one of the conductive patterns.
5. The semiconductor device of any preceding clause, wherein the contact plug is between the inner supporter and an adjacent one of the outer supporters.
6. The semiconductor device of any preceding clause, wherein a distance between the inner supporter and an adjacent one of the outer supporters is less than a maximum diameter of the contact plug.
7. The semiconductor device of any preceding clause, wherein a width of the inner supporter is greater than respective widths of the outer supporters.
8. The semiconductor device of any preceding clause, wherein a lower portion of the inner supporter has a width that is less than a width of an upper portion of the inner supporter.
9. The semiconductor device of any preceding clause, wherein the contact plug has a first thickness between a sidewall of the insulating spacer and a sidewall of the inner supporter, and
   wherein the first thickness is less than a diameter of the inner supporter.
10. The semiconductor device of any preceding clause, wherein the substrate further comprises a cell array region, the semiconductor device further comprising:
   vertical channels that penetrate the stacked structure on the cell array region,
   wherein upper surfaces of the vertical channels are at different distances from the substrate than upper surfaces of the inner supporter and the outer supporters.
11. The semiconductor device of any preceding clause, wherein the stacked structure at least partially extends around the inner supporter and the outer supporters in the plan view.
12. A semiconductor device comprising:
   a substrate including a cell array region and a connection region;
   a stacked structure including conductive patterns stacked on the substrate;
   vertical channels that extend into the stacked structure on the cell array region;
   a first contact plug that extends into the stacked structure on the connection region and is electrically connected to a first one of the conductive patterns;
   a second contact plug that extends into the stacked structure on the connection region and is electrically connected to a second one of the conductive patterns;
   a first inner supporter that extends into the first contact plug;
   a second inner supporter that extends into the second contact plug;
   a first insulating spacer between the first contact plug and the stacked structure, wherein the first insulating spacer at least partially extends around the first contact plug in plan view;
   a second insulating spacer between the second contact plug and the stacked structure, wherein the second insulating spacer at least partially extends around the second contact plug in the plan view; and
   a plurality of outer supporters that extend into the stacked structure and are spaced apart from the first and second contact plugs on the connection region.
13. The semiconductor device of clause 12, wherein upper surfaces of the first and second contact plugs are substantially a same distance from the substrate.
14. The semiconductor device of clause 12 or clause 13, wherein upper surfaces of the first and second contact plugs and upper surfaces of the first and second inner supporters are substantially a same distance from the substrate.
15. The semiconductor device of any of clauses 12 to 14, wherein the first and second inner supporters have substantially a same length in a direction perpendicular to an upper surface of the substrate.
16. The semiconductor device of any of clauses 12 to 15, wherein each of the first and second inner supporters includes a through conductive plug that extends into the stacked structure and a through insulating spacer that at least partially extends around the through conductive plug in the plan view.
17. The semiconductor device of any of clauses 12 to 16, wherein the first and second inner supporters include respective first insulating pillars and the outer supporters include respective second insulating pillars.
18. The semiconductor device of any of clauses 12 to 17, wherein a diameter of the first contact plug is different from a diameter of the second contact plug.
19. The semiconductor device of any of clauses 12 to 18, wherein each of the conductive patterns at least partially extends around the first and second inner supporters and the outer supporters in the plan view.
20. An electronic system comprising:
   a semiconductor device including a substrate comprising a connection region;
   a stacked structure including conductive patterns stacked on the substrate;
   an inner supporter that extends into the stacked structure in the connection region;
   a contact plug that extends into a portion of the stacked structure and is electrically connected to one of the conductive patterns, wherein the contact plug at least partially extends around the inner supporter in plan view;
   an insulating spacer between the contact plug and the stacked structure, wherein the insulating spacer at least partially extends around the contact plug in the plan view;
   outer supporters that extend into the stacked structure and are spaced apart from the contact plug;
   an input/output pad electrically connected to peripheral circuits; and
   a controller electrically connected to the semiconductor device through the input/output pad and configured to control the semiconductor device.

## Claims

1. A semiconductor device comprising:
a substrate including a connection region;
a stacked structure including conductive patterns stacked on the substrate;
an inner supporter that extends into the stacked structure in the connection region;
a contact plug that extends into the stacked structure and is electrically connected to one of the conductive patterns, wherein the contact plug at least partially extends around the inner supporter in plan view;
an insulating spacer between the contact plug and the stacked structure, wherein the insulating spacer at least partially extends around the contact plug in the plan view; and
outer supporters in the connection region, wherein the outer supporters are spaced apart from the contact plug and extend into the stacked structure.

2. The semiconductor device of claim 1, wherein the inner supporter includes a first insulating pillar and the outer supporters include respective second insulating pillars.

3. The semiconductor device of claim 1 or claim 2, wherein the inner supporter includes a through conductive plug that extends into the stacked structure, and a through insulating spacer that at least partially extends around the through conductive plug in the plan view.

4. The semiconductor device of any preceding claim, wherein the contact plug and the insulating spacer are in contact with an upper surface of one of the conductive patterns.

5. The semiconductor device of any preceding claim, wherein the contact plug is between the inner supporter and an adjacent one of the outer supporters.

6. The semiconductor device of any preceding claim, wherein a distance between the inner supporter and an adjacent one of the outer supporters is less than a maximum diameter of the contact plug.

7. The semiconductor device of any preceding claim, wherein a width of the inner supporter is greater than respective widths of the outer supporters.

8. The semiconductor device of any preceding claim, wherein a lower portion of the inner supporter has a width that is less than a width of an upper portion of the inner supporter.

9. The semiconductor device of any preceding claim, wherein the contact plug has a first thickness between a sidewall of the insulating spacer and a sidewall of the inner supporter, and
wherein the first thickness is less than a diameter of the inner supporter.

10. The semiconductor device of any preceding claim, wherein the substrate further comprises a cell array region, the semiconductor device further comprising:
vertical channels that penetrate the stacked structure on the cell array region,
wherein upper surfaces of the vertical channels are at different distances from the substrate than upper surfaces of the inner supporter and the outer supporters.

11. The semiconductor device of any preceding claim, wherein the stacked structure at least partially extends around the inner supporter and the outer supporters in the plan view.

12. The semiconductor device of any preceding claim, further comprising:
a first contact plug that extends into the stacked structure on the connection region and is electrically connected to a first one of the conductive patterns;
a second contact plug that extends into the stacked structure on the connection region and is electrically connected to a second one of the conductive patterns;
a first inner supporter that extends into the first contact plug;
a second inner supporter that extends into the second contact plug;
a first insulating spacer between the first contact plug and the stacked structure, wherein the first insulating spacer at least partially extends around the first contact plug in plan view; and
a second insulating spacer between the second contact plug and the stacked structure, wherein the second insulating spacer at least partially extends around the second contact plug in the plan view.

13. The semiconductor device of claim 12, wherein upper surfaces of the first and second contact plugs are substantially a same distance from the substrate.

14. The semiconductor device of claim 12 or claim 13, wherein upper surfaces of the first and second contact plugs and upper surfaces of the first and second inner supporters are substantially a same distance from the substrate.

15. The semiconductor device of any of claims 12 to 14, wherein the first and second inner supporters have substantially a same length in a direction perpendicular to an upper surface of the substrate.
